# EUROPEAN PATENT APPLICATION

(11) **EP 4 581 951 A1**
(43) Date of publication of application: **09.07.2025**
(21) Application number: 23876521.8
(22) Date of filing: 25.09.2023
(51) Int. Cl.: A24F 40/40, A24F 40/46

(54) **ELECTRONIC ATOMIZATION DEVICE, POWER SOURCE MECHANISM FOR ELECTRONIC ATOMIZATION DEVICE, AND CIRCUIT BOARD**

(30) Priority: 14.10.2022 CN 202211262392
(71) Applicant: Shenzhen First Union Technology Co., Ltd., Shenzhen, Guangdong 518000 (CN)
(72) Inventor: CHEN, Hanliang, Shenzhen, Guangdong 518000 (CN); KUANG, Huanzhen, Shenzhen, Guangdong 518000 (CN); LU, Linhai, Shenzhen, Guangdong 518000 (CN); XU, Wei, Shenzhen, Guangdong 518000 (CN); ZOU, Weisong, Shenzhen, Guangdong 518000 (CN); XU, Zhongli, Shenzhen, Guangdong 518000 (CN); LI, Yonghai, Shenzhen, Guangdong 518000 (CN)
(74) Representative: Viering, Jentschura & Partner mbB Patent- und Rechtsanwälte
(86) International application number: PCT/CN2023/121210
(87) International publication number: WO 2024/078317

(57) **Abstract**

An electronic atomization device, a power supply mechanism (200) for the electronic atomization device, and a circuit board for the electronic atomization device are provided. The electronic atomization device includes: a heating element (13); a battery cell (21) for supplying power; a charging assembly for charging; and a circuit board assembly (30), at least comprising: a first portion (31), located between the battery cell (21) and a second side (2140) in a width direction, where a micro control unit (MCU) controller (43) is arranged on the first portion (31) to control the battery cell (21) to supply electric power to the heating element (13); a second portion (32), extending from the first portion (31) toward a first side (2130), where the second portion (32) is configured to output the electric power of the battery cell (21) to the heating element (13); and a third portion (33), extending from the first portion (31) toward the first side (2130), where the third portion (33) is connected to a charging assembly. According to the foregoing electronic atomization device, the circuit board assembly (30) is divided into a plurality of portions, thereby facilitating both preparation and assembling.

## Description

### CROSS-REFERENCE TO RELATED APPLICATIONS

This application claims priority to Chinese Patent Application No. 202211262392.X, filed with the China National Intellectual Property Administration on October 14, 2022 and entitled "ELECTRONIC ATOMIZATION DEVICE, POWER SUPPLY MECHANISM FOR ELECTRONIC ATOMIZATION DEVICE, AND CIRCUIT BOARD FOR ELECTRONIC ATOMIZATION DEVICE", which is incorporated herein by reference in its entirety.

### TECHNICAL FIELD

Embodiments of the present application relate to the field of electronic atomization technologies, and in particular, to an electronic atomization device, a power supply mechanism for the electronic atomization device, and a circuit board for the electronic atomization device.

### BACKGROUND

Tobacco products (such as cigarettes, cigars, and the like) burn tobacco during use to produce tobacco smoke. Attempts are made to replace these tobacco-burning products by making products that release compounds without burning.

An example of such products is a heating device, which releases compounds by heating rather than burning materials. For example, the material may be tobacco or other non-tobacco products. These non-tobacco products may or may not include nicotine. In another example, aerosol-providing articles are provided, for example, a so-called electronic atomization device. These electronic atomization devices usually include a liquid aerosol-forming matrix. The liquid aerosol-forming matrix is heated to be atomized, thus forming an inhalable aerosol.

### SUMMARY

An embodiment of the present application provides an electronic atomization device, including a first side and a second side which face away from each other in a width direction, and:
a heating element, configured to heat an aerosol-forming matrix to form an aerosol;
a battery cell, configured to supply power; and
a charging assembly, configured to charge the battery cell; and
a circuit board assembly, at least including:
   a first portion, located between the battery cell and the second side in the width direction of the electronic atomization device, where a controller is arranged on the first portion, and the controller is configured to control the battery cell to supply electric power to the heating element;
   a second portion, extending from the first portion toward the first side, where the second portion is configured to be electrically connected to the heating element, to output the electric power of the battery cell to the heating element; and
   a third portion, extending from the first portion toward the first side, where the third portion is connected to the charging assembly.

In some other implementations, the electronic atomization device includes a near end and a far end which face away from each other in a length direction, where the third portion is closer to the far end than the second portion.

In some other implementations, the second portion and/or the third portion are substantially perpendicular to the first portion.

In some other implementations, the second portion and the third portion are perpendicular to each other;
alternatively, the second portion and the third portion are parallel to each other.

In some other implementations, any two of the first portion, the second portion, and the third portion are perpendicular to each other.

In some other implementations, the first portion is arranged perpendicular to the width direction of the electronic atomization device.

In some other implementations, the second portion and the third portion are arranged on a same side of the first portion in a thickness direction of the electronic atomization device.

In some other implementations, a length dimension of the first portion extending in the length direction of the electronic atomization device is greater than a width dimension of the second portion extending in the width direction of the electronic atomization device.

In some other implementations, the length dimension of the first portion is between 40 mm and 60 mm;
and/or a width dimension of the second portion is between 10 mm and 18 mm;
and/or a width dimension of the third portion is between 6 mm and 12 mm.

In some other implementations, the controller is arranged on a surface of the first portion that faces away from the battery cell.

In some other implementations, the circuit board assembly further includes:
a fourth portion, extending from the first portion toward the first side; a temperature sensor abutting against or adjacent to the battery cell is arranged on the fourth portion, to sense a temperature of the battery cell; and
the controller is configured to prevent or reduce the electric power output by the battery cell when a temperature sensed by the temperature sensor is greater than a preset threshold.

In some other implementations, the temperature sensor is combined with or arranged on a surface of the fourth portion that faces away from the battery cell.

In some other implementations, the fourth portion is located between the second portion and the third portion in the length direction of the electronic atomization device.

In some other implementations, a width dimension of the fourth portion extending in the width direction of the electronic atomization device is less than a width dimension of the second portion or the third portion extending in the width direction of the electronic atomization device.

In some other implementations, the circuit board assembly further includes:
a fourth portion, extending from the first portion toward the first side; a thermistor abutting against or adjacent to the battery cell is arranged on the fourth portion; and
the controller is configured to prevent or reduce the battery cell from outputting electric power when an electrical characteristic of the thermistor exceeds a preset threshold.

In some other implementations, the electrical characteristic includes a voltage value and/or a resistance value.

In some other implementations, the electronic atomization device further includes:
a plurality of light sources, configured to emit light,
where the controller is configured to control, based on a change in a positive electrode voltage or an output voltage of the battery cell, the plurality of light sources to emit light in different quantities.

In some other implementations, the controller is configured to:
control, when the positive electrode voltage or the output voltage of the battery cell is greater than a first threshold, the plurality of light sources to emit light in a first quantity; and
control, when the positive electrode voltage or the output voltage of the battery cell is less than the first threshold, the plurality of light sources to emit light in a second quantity; and the second quantity is less than the first quantity.

In some other implementations, the electronic atomization device further includes:
one or more light sources, configured to emit light, where the one or more light sources are arranged on a surface of the first portion that faces the second side.

In some other implementations, the circuit board assembly includes:
at least one substrate layer, and a conductive line and/or an electronic device arranged on the substrate layer; and the first portion, the second portion, or the third portion includes a portion of the substrate layer.

In some other implementations, the substrate layer includes at least one of a polyimide layer, a polytetrafluoroethylene layer, a polycarbonate layer, a polyester layer, an aluminum foil layer, and a stainless steel layer.

In some other implementations, hardness of the first portion is greater than hardness of the second portion and/or the third portion.

In some other implementations, the first portion at least includes:
a soft first substrate layer; and
a hard second substrate layer.

In some other implementations, the first portion includes a stainless steel layer.

In some other implementations, the second portion and/or the third portion includes an organic polymer layer.

In some other implementations, the first portion, the second portion, and the third portion are formed by bending a sheet base material.

In some other implementations, the second portion is in non-contact with the battery cell;
and/or the third portion at least partially abuts against or is at least partially combined with a surface of the battery cell.

In some other implementations, the second portion is located between the battery cell and the near end.

In some other implementations, the electronic atomization device further includes:
an electrical contact, electrically connected between the second portion and the heating element, where during use, the second portion is in conductive connection to the heating element through the electrical contact, to output the electric power of the battery cell to the heating element.

In some other implementations, the second portion is provided with:
a contact connection portion, identified by a color or a pattern; and the electrical contact is electrically connected to the contact connection portion to form electrical conduction with the second portion.

In some other implementations, the contact connection portion is identified and defined by a circle pattern that is formed on the second portion and has an identifiable color.

In some other implementations, the electronic atomization device further includes:
a sensor, arranged or combined on the second portion, to sense an airflow flowing through the electronic atomization device during inhalation of a user;
the contact connection portion includes a first contact connection portion and a second contact connection portion that are spaced apart; and the sensor is located between the first contact connection portion and the second contact connection portion.

In some other implementations, the electronic atomization device further includes:
a support, a first support part and a second support part that are arranged in the length direction of the electronic atomization device, where the first support part is closer to the near end than the second support part;
the electrical contact is at least partially maintained at the first support part; and
the battery cell is at least partially maintained at the second support part.

In some other implementations, the first support part is moulded by a mouldable material and at least partially surrounds the electrical contact.

In some other implementations, the second portion is at least partially accommodated between the first support part and the second support part.

In some other implementations, the electronic atomization device further includes:
a sensor, arranged or combined on the second portion, to sense a change in an airflow flowing through the electronic atomization device during inhalation of a user; and
the controller is configured to control, based on a sensing result of the sensor, the battery cell to supply the electric power to the heating element.

In some other implementations, the electronic atomization device further includes:
a sensor, arranged or combined on the second portion, to sense a pressure difference between a pressure, caused by an airflow flowing through the electronic atomization device during inhalation of a user, and an environmental atmospheric pressure,
where the controller is configured to control, based on the pressure difference, the battery cell to supply the electric power to the heating element.

In some other implementations, the controller is configured to control, when the pressure difference is greater than a preset threshold, the battery cell to supply the electric power to the heating element.

In some other implementations, the controller is configured to control the battery cell to supply the electric power to the heating element proportionally or linearly according to the pressure difference.

In some other implementations, a volume of the sensor is less than 12 mm3.

In some other implementations, the sensor has a length of 2 to 3.5 mm, a width of 1.5 to 2.5 mm, and a thickness of 0.6 to 1.4 mm.

In some other implementations, the sensor is a micro electro mechanical system (MEMS)-based sensor.

In some other implementations, the sensor is arranged in a manner of deviating from a central axis of the electronic atomization device.

In some other implementations, the sensor is basically square; and
the sensor is perpendicular to the length direction of the electronic atomization device, or the sensor is parallel to the length direction of the electronic atomization device.

In some other implementations, the sensor includes:
a first sensing surface, configured to sense the pressure caused by the airflow flowing through the electronic atomization device during the inhalation of the user; and a second sensing surface, configured to sense the environmental atmospheric pressure, where
the first sensing surface is combined with or abuts against the second portion; and
the second sensing surface is at least partially exposed inside the electronic atomization device.

In some other implementations, the second portion includes a soft substrate layer made of an organic polymer material; and
the first sensing surface is at least partially combined with the substrate layer, so that at least a portion of the substrate layer provides airtight sealing between the second portion and the first sensing surface.

In some other implementations, the electronic atomization device further includes:
a support, configured to accommodate or maintain the battery cell; and
an air channel, at least partially defined on the support, to provide a channel for communicating the first sensing surface to the airflow flowing through the electronic atomization device during the inhalation.

In some other implementations, the electronic atomization device further includes:
a flexible seal element, at least partially located between the second portion and the support and surrounding the air channel, to provide sealing between the second portion and the air channel.

In some other implementations, the electronic atomization device further includes:
a first air hole, penetrating through two opposite sides of the second portion, to provide a channel for communicating the first sensing surface to the airflow of the air channel, where the first sensing surface covers the first air hole.

In some other implementations, the air channel includes: a first channel portion close to the first sensing surface and a second channel portion facing away from the first sensing surface; and
an angle is formed between the first channel portion and the second channel portion, or the first channel portion and the second channel portion are vertically arranged.

In some other implementations, the air channel includes: a first channel portion close to the first sensing surface and a second channel portion facing away from the first sensing surface; and a cross-sectional area of the first channel portion is smaller than a cross-sectional area of the second channel portion.

In some other implementations, the seal element at least includes:
a first surface, abutting against or combined with the second portion;
a second surface, abutting against or combined with the support; and
a second air hole, extending from the first surface to the second surface, to provide a channel for communicating the first sensing surface with the airflow of the air channel.

In some other implementations, the seal element further includes:
a first convex rib, located on the first surface, where the first convex rib defines at least one closed ring surrounding the second air hole;
and/or a second convex rib, located on the second surface, where the second convex rib defines at least one closed ring surrounding the second air hole and/or the air channel.

In some other implementations, the second air hole deviates from a center of the seal element.

In some other implementations, the seal element at least partially extends into the air channel.

In some other implementations, the seal element includes:
a base portion, at least partially located between the second portion and the support and surrounding the air channel, to provide sealing between the second portion and the air channel; and
an extension portion, extending away from the base portion and at least partially extending into the air channel.

In some other implementations, the electronic atomization device includes:
a retaining wall, extending in the length direction of the electronic atomization device and arranged substantially perpendicular to the width direction of the electronic atomization device,
where the battery cell is at least partially accommodated between the retaining wall and the first side and abuts against the retaining wall; and
the first portion is at least partially accommodated between the retaining wall and the second side and abuts against the retaining wall.

In some other implementations, a distance between the retaining wall and the first side is greater than a distance between the retaining wall and the second side.

In some other implementations, a distance between the retaining wall and the first side is between 10 mm and 20 mm;
and/or a distance between the retaining wall and the second side is between 5 mm and 10 mm.

In some other implementations, the electronic atomization device further includes:
a fastening component, at least partially accommodated between the first portion and the second side, to securely press the first portion against the retaining wall.

In some other implementations, at least one convex post extending toward the second side is arranged on the retaining wall; and
a hole through which the convex post passes is provided in the first portion.

In some other implementations, the first portion and the second portion are connected through a flat flexible cable;
and/or the first portion is connected to the third portion through a flat flexible cable.

In some other implementations, the charging assembly includes:
a charging circuit board and a charging interface combined with the charging circuit board;
a surface of the charging circuit board facing away from the charging interface is provided with:
   a battery cell connection portion, where a positive electrode and negative electrode of the battery cell are connected to the battery cell connection portion; and
   a circuit connection portion, where the third portion is connected to the circuit connection portion.

In some other implementations, the battery cell connection portion and the circuit connection portion have different shapes and/or colors.

Another embodiment of the present application further provides an electronic atomization device, including a first side and a second side which face away from each other in a width direction, and:
a heating element, configured to heat an aerosol-forming matrix to form an aerosol;
a battery cell, configured to supply power;
a charging assembly, configured to charge the battery cell; and
a circuit board assembly, at least including:
   a first portion, located between the battery cell and the second side in the width direction of the electronic atomization device, where a controller is arranged on the first portion, and the controller is configured to control the battery cell to supply electric power to the heating element;
   a second portion, extending from the first portion toward the first side, where a sensor is arranged on the second portion, to sense an airflow flowing through the electronic atomization device during inhalation of a user; and
   a third portion, extending from the first portion toward the first side, where the third portion is connected to the charging assembly.

Another embodiment of the present application further provides an electronic atomization device, including a first side and a second side which face away from each other in a width direction, and:
a heating element, configured to heat an aerosol-forming matrix to form an aerosol;
a battery cell, configured to supply power;
a charging assembly, configured to charge the battery cell; and
a circuit board assembly, at least including:
   a first portion, located between the battery cell and the second side in the width direction of the electronic atomization device, where a controller is arranged on the first portion and at least configured to control the battery cell to supply electric power to the heating element;
   a second portion, extending from the first portion toward the first side, to output the electric power of the battery cell to the heating element,
   a third portion, extending from the first portion toward the first side, where the third portion is connected to the charging assembly; and
   any two of the first portion, the second portion, and the third portion are perpendicular to each other.

Another embodiment of the present application further provides an electronic atomization device, including a first side and a second side which face away from each other in a width direction, and:
a heating element, configured to heat an aerosol-forming matrix to form an aerosol;
a battery cell, configured to supply power;
a circuit board assembly, at least including:
   a first portion, located between the battery cell and the second side in the width direction of the electronic atomization device, where a controller is arranged on the first portion and at least configured to control the battery cell to supply electric power to the heating element;
   a second portion, extending from the first portion toward the first side, to output the electric power of the battery cell to the heating element,
   where the first portion includes a stainless steel layer and a flexible organic polymer layer combined with the stainless steel layer.

Another embodiment of the present application further provides an electronic atomization device, including a first side and a second side which face away from each other in a width direction, and:
a heating element, configured to heat an aerosol-forming matrix to form an aerosol;
a battery cell, configured to supply power;
a first circuit board, located between the battery cell and the second side in the width direction of the electronic atomization device, where a first circuit board is configured to control the battery cell to supply electric power to the heating element; and
a second circuit board, located between the heating element and the battery cell in a length direction of the electronic atomization device, where a sensor is arranged on the second circuit board, to sense an airflow flowing through the electronic atomization device during inhalation of a user; and
the first circuit board and the second circuit board are connected through a flat flexible cable.

Another embodiment of the present application further provides an electronic atomization device, including a first side and a second side which face away from each other in a width direction, and:
a heating element, configured to heat an aerosol-forming matrix to form an aerosol;
a battery cell, configured to supply power;
a circuit board assembly, at least including:
   a first portion, located between the battery cell and the second side in the width direction of the electronic atomization device, where a controller is arranged on the first portion and at least configured to control the battery cell to supply electric power to the heating element;
   a second portion, extending from the first portion toward the first side, where a sensor is arranged on the second portion, to sense an airflow flowing through the electronic atomization device during inhalation of a user; and
   a retaining wall, extending in the length direction of the electronic atomization device and arranged substantially perpendicular to the width direction of the electronic atomization device,
   where the battery cell is at least partially accommodated or maintained between the retaining wall and the first side and abuts against the retaining wall; and
   the first portion is at least partially accommodated or maintained between the retaining wall and the second side and abuts against the retaining wall.

Still another embodiment of the present application further provides power supply mechanism for an electronic atomization device, configured to supply power to the electronic atomization device, and including a first side and a second side which face away from each other in a width direction, and:
a receiving cavity, configured to receive at least a portion of the atomizer;
a battery cell, configured to supply power;
a charging assembly, configured to charge the battery cell; and
a circuit board assembly, at least including:
   a first portion, located between the battery cell and the second side in the width direction of the power supply mechanism, where a controller being arranged on the first portion and at least configured to control the battery cell to supply electric power to the atomizer;
   a second portion, extending from the first portion toward the first side, where the second portion being configured to output the electric power of the battery cell to the atomizer; and
   a third portion, extending from the first portion toward the first side in the width direction of the power supply mechanism, where the third portion is connected to the charging assembly.

Yet another embodiment of the present application further provides a circuit board for the electronic atomization device, having a first end and a second end that deviate from each other in a length direction, and a first side and a second side that extend between the first end and the second end and deviate from each other, where the circuit board includes:
a first portion, extending between the first end and the second end, where a controller is arranged on the first portion;
a second portion, extending from the first portion toward the first side and being close to the first end, where a sensor for sensing an airflow is arranged on the second portion; and
a third portion, extending from the first portion toward the first side and being close to the second end, where the third portion is configured to be connected to a charging assembly that charges the electronic atomization device.

According to the foregoing electronic atomization device, the circuit board assembly is divided into a plurality of portions, which is advantageous for preparation and assembling.

### BRIEF DESCRIPTION OF THE DRAWINGS

One or more embodiments are exemplarily described with reference to the corresponding figures in the accompanying drawings, and the descriptions are not to be construed as limiting the embodiments. Elements in the accompanying drawings that have same reference numerals are represented as similar elements, and unless otherwise particularly stated, the figures in the accompanying drawings are not drawn to scale.
FIG. 1 is a schematic diagram of an electronic atomization device according to an embodiment;
FIG. 2 is a schematic structural diagram of a power supply mechanism in FIG. 1 according to an embodiment;
FIG. 3 is a schematic cross-sectional view of a power supply mechanism in FIG. 1 in one angle;
FIG. 4 is a schematic exploded diagram of the power supply mechanism in FIG. 3 in one angle;
FIG. 5 is a schematic exploded diagram of some components of the power supply mechanism in FIG. 4 in another angle;
FIG. 6 is a schematic exploded diagram of some components of the power supply mechanism in FIG. 4 in another angle;
FIG. 7 is a schematic diagram of some components of the power supply mechanism in FIG. 4 after assembling, in one angle;
FIG. 8 is a schematic diagram of some components of the power supply mechanism in FIG. 4 after assembling in another angle;
FIG. 9 is a schematic diagram of a support in FIG. 4 from another perspective.
FIG. 10 is a schematic diagram of a circuit board assembly in FIG. 4 in another angle;
FIG. 11 is a schematic diagram of a seal element in FIG. 6 in one angle;
FIG. 12 is a schematic diagram of a seal element in FIG. 6 in another angle;
FIG. 13 is a schematic cross-sectional diagram of a portion of a circuit component;
FIG. 14 is a schematic cross-sectional view of a power supply mechanism in FIG. 1 in another angle;
FIG. 15 is a schematic exploded view of some components of a power supply mechanism device according to another embodiment in one angle;
FIG. 16 is a schematic exploded diagram of some components of the power supply mechanism in FIG. 15 in another angle;
FIG. 17 is a schematic exploded diagram of some components of the power supply mechanism in FIG. 15 in another angle;
FIG. 18 is a schematic exploded diagram of the power supply mechanism in FIG. 15 in another angle;
FIG. 19 is a schematic diagram of a seal element in FIG. 17 in another angle;
FIG. 20 is a schematic diagram of a seal element in FIG. 19 in another angle; and
FIG. 21 is a schematic diagram of a seal element in FIG. 16 in another angle.

### DETAILED DESCRIPTION

For ease of understanding of the present application, the present application is described below in more detail with reference to accompanying drawings and specific implementations.

An embodiment of the present application provides an electronic atomization device, configured to heat a liquid aerosol-forming matrix to form an aerosol for inhalation. Alternatively, in some other embodiments, the aerosol-forming matrix may be a solid or a colloid.

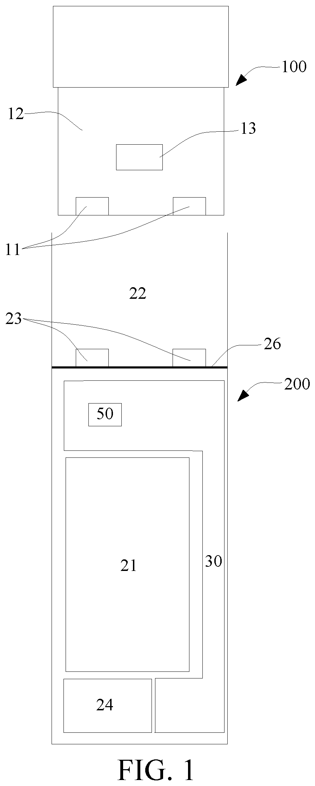

An embodiment of the present application provides an electronic atomization device. Referring to FIG. 1, the electronic atomization device includes an atomizer 100 for storing a liquid aerosol-forming matrix and atomizing the liquid aerosol-forming matrix to form an aerosol, and a power supply mechanism 200 for supplying power to the atomizer 100.

In an optional implementation, for example, as shown in FIG. 1, the atomizer 100 includes:
a liquid storage cavity 12 configured to store a liquid aerosol-forming matrix;
a heating element 13 configured to heat and atomize the liquid aerosol-forming matrix to form an aerosol;
and an electrical contact 11 electrically connected to the heating element 13, to guide a current on the heating element 13 during use.

In an optional implementation, for example, as shown in FIG. 1, the power supply mechanism 200 includes: a receiving cavity 27 arranged at one end in a length direction and configured to receive and accommodate at least a portion of the atomizer 100; and an electrical contact 23 at least partially exposed out of a surface of the receiving cavity 27 and configured to supply power to the atomizer 100 when at least a portion of the atomizer 100 is received and accommodated in the power supply mechanism 200.

According to the implementation shown in FIG. 1, the electrical contact 11 is arranged at an end portion of the atomizer 100 opposite to the power supply mechanism 200 in the length direction, so that when at least a portion of the atomizer 100 is received in the receiving cavity 27, the electrical contact 11 is in contact with and abuts against the electrical contact 23 to conduct electricity.

A seal element 26 is arranged in the power supply mechanism 200, and at least a portion of an internal space of the power supply mechanism 200 is separated through the seal element 26 to form the above receiving cavity 27. In the implementation shown in FIG. 1, the seal element 26 is configured to extend in a cross section direction of the power supply mechanism 200, and is optionally prepared by using a flexible material such as silica gel, so as to prevent the liquid aerosol-forming matrix seeping from the atomizer 100 to the receiving cavity 27 from flowing into the power supply mechanism 200.

In the implementation shown in FIG. 1, the power supply mechanism 200 further includes a battery cell 21 for supplying power; and a circuit board assembly 30, which operably guides a current between the battery cell 21 and the electrical contact 23.

During use, the power supply mechanism 200 includes a sensor 50, configured to sense an inhalation airflow generated by the atomizer 100 during inhalation, so that the circuit board assembly 30 controls the battery cell 21, based on a detection signal of the sensor 50, to supply power to the atomizer 100.

Further, in the implementation shown in FIG. 1, a charging interface 24 is arranged on the other end of the power supply mechanism 200 facing away from the receiving cavity 27, and is configured to supply power to the battery cell 21. The charging interface 24 is a USB Type-C interface. Alternatively, in some other changed embodiments, the charging interface 24 may further use a USB 2.0 interface, a USB 3.0 interface, or a USB 4-pin interface.

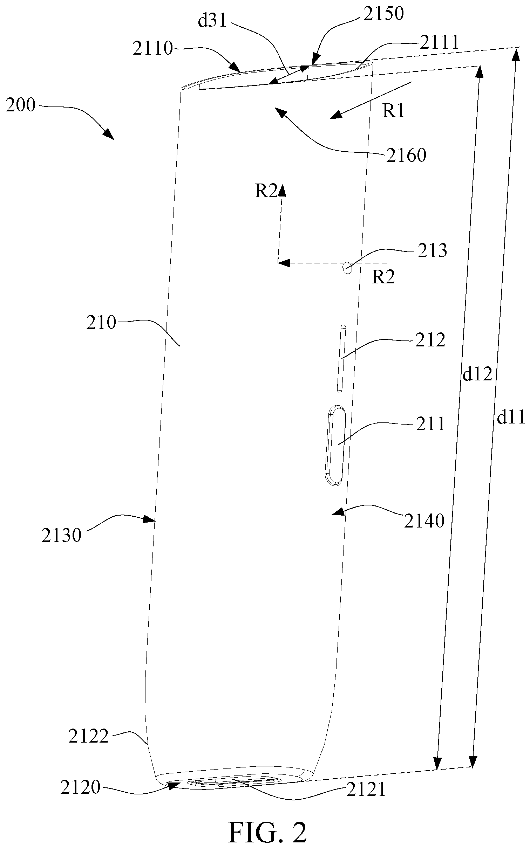

The embodiments in FIG. 2 to FIG. 3 show schematic structural diagrams of the power supply mechanism 200 in FIG. 1 according to an embodiment, including:
a shell 210 which is lengthwise cylindrical. In addition, during implementation, a length of the shell 210 is greater than a width, and the width is greater than a thickness, so that the shell 210 is constructed into a flat shape.

In addition, in some implementations, a length dimension d11 of the shell 210 is between 70 mm and 100 mm. In addition, a width dimension d21 of the shell 210 is between 15 mm and 25 mm. Moreover, a thickness dimension d31 of the shell 210 is between 8 mm and 15 mm.

In some examples, the shell 210 may be formed by a metal or alloy such as stainless steel or aluminum. Other suitable materials including various types of plastic (e.g. polycarbonate), metal-plating over plastic, ceramic, and the like may alternatively be used.

The shell 210 includes a near end 2110 and a far end 2120 that face away from each other in the length direction. During use, the near end 2110 is an end portion for accommodating and receiving the atomizer 100, and the far end 2120 is an end portion for being connected to an external charging device, to charge the power supply mechanism 200.

The shell 210 has a front side 2150 and a rear side 2160 that face away from each other in a thickness direction. The shell 210 has a surface 2111 at the near end 2110, and the surface 2111 is inclined. Specifically, as shown by arrow R1 in FIG. 2, the surface 2111 is obliquely arranged from the front side 2150 to the rear side 2160 in the thickness direction. Specifically, a distance d11 between the front side 2150 of the surface 2111 and the far end 2120 is the length dimension d11 of the shell 210. In addition, a distance d12 between the rear side 2160 of the surface 2111 and the far end 2120 is less than the length dimension d11 of the shell 210. A distance d12 between the rear side 2160 of the surface 2111 and the far end 2120 is between 75 mm and 95 mm.

The receiving cavity 27 of the power supply mechanism 200 is opened at the near end 2110, to receive the atomizer 100. In addition, an extension dimension d13 of the receiving cavity 27 in the length direction of the power supply mechanism 200 is between 20 mm to 30 mm.

The shell 210 has an opening 2122 located at the far end 2120, to expose the charging interface 24. In addition, the shell 210 has a section 2122 close to or located at the far end 2120. A width dimension and/or a thickness dimension of the section 2122 gradually decreases in a direction close to the far end 2120, so that a portion of the shell 210 close to the far end 2120 has a gradually contracted or gathered shape. In addition, in some embodiments, an extension length d14 of the section 2122 is between 8 mm to 20 mm.

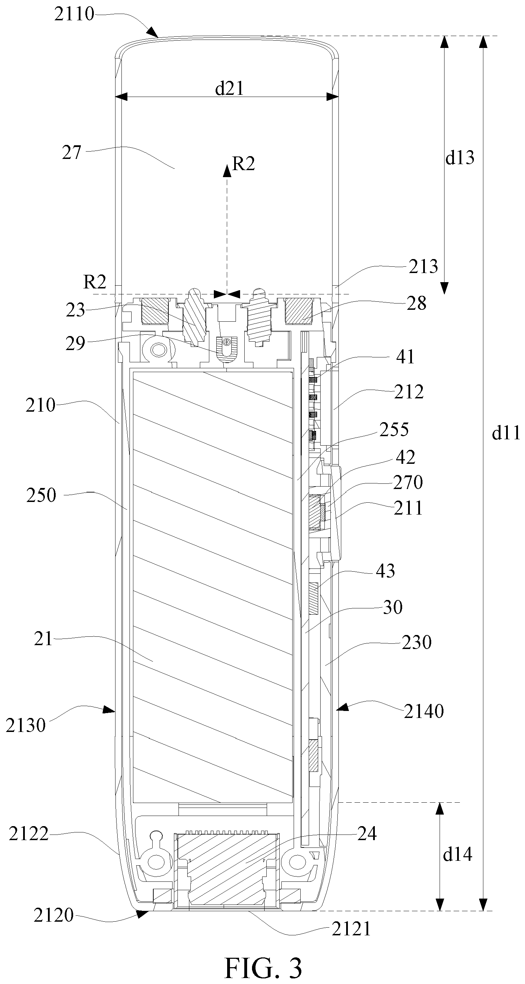

In addition, further, as shown in FIG. 2 and FIG. 3, the shell 210 further includes:
a first side 2130 and a second side 2140 that face away from each other in a width direction.

Further, as shown in FIG. 2 and FIG. 3, the shell 210 is provided with:
an air inlet 213, configured to allow, when a user puffs on the atomizer 100, external air to enter the receiving cavity 27 and further enter the atomizer 100, as shown by arrow R2 in FIG. 2 and FIG. 3. The air inlet 213 is located on or arranged on the first side 2130 and/or the second side 2140. In addition, in the embodiment shown in FIG. 3, in the width direction of the power supply mechanism 200, the air inlet 213 is substantially flush with an end portion of the receiving cavity 27 that faces away from the near end 2110.

Further, as shown in FIG. 2 and FIG. 3, the shell 210 is provided with:
an input element 211 operated by a user to form an input signal. Then, the power supply mechanism 200 selectively switches between a locked state and an unlocked state according to the input signal of the user. For example, in the locked state, the power supply mechanism 200 is prevented from outputting power to the atomizer 100, and in the unlocked state, the power supply mechanism 200 is allowed to output power to the atomizer 100.

In some other implementations, the input element 211 is selected from a mechanical button, a film button, a mechanical switch, a rotary encoder, a dial, a knob, a capacitive touch button, a resistive touch button, an operating lever, a slider, a trigger button, a touch screen, and a magnetic switch. In the implementations shown in FIG. 2 and FIG. 3, the input element 211 is, for example, a mechanical button. The power supply mechanism 200 controls, according to an input signal of the input element 211, for example, a pressing action or event performed by a user using the mechanical button, to lock or unlock the power supply mechanism 200.

Further, as shown in FIG. 2 and FIG. 3, the shell 210 is provided with:
a light source hole 212, configured to allow light emitted by a light source 41 to pass through the shell 210 through the light source hole 212, so as to be received by a user. In some implementations, a user may observe a light-emitting state of the light source 41 through the light source hole 212, to determine a current battery level of the power supply mechanism 200.

In some embodiments, a plurality of light sources 41 are provided. One or more of the light sources 41 may be turned on to emit light, to prompt a user of different battery levels of the power supply mechanism 200. For example, in a specific embodiment, four light sources 41 are provided, which are arranged in sequence in the length direction. During implementation, the four light sources 41 may be made to emit light simultaneously, so as to inform a user that a current battery level is full or is relatively sufficient. In addition, only one of the light sources 41 is made to emit light, to inform the user that a current battery level is low, so as to prompt the user of charging. In addition, only two or three of the light sources 41 may be made to emit light simultaneously, to prompt the user of a current battery level. For example, when three of the light sources 41 emit light simultaneously, it indicates that a current battery level is less than a battery level when the four light sources emit light simultaneously and greater than a battery level when two of the light sources 41 emit light simultaneously. For another example, when two of the light sources 41 emit light simultaneously, it indicates that a current battery level is less than a battery level when three light sources emit light simultaneously and greater than a battery level when only one light source emits light.

In some embodiments, the light sources 41 include light-emitting diodes (LEDs).

In addition, in some embodiments, the input element 211 and the light source hole 212 are both arranged on the second side 2140. In some embodiments, the light source hole 212 is closer to the near end 2110 than the input element 211. In addition, the input element 211 and the light source hole 212 avoid the receiving cavity 27. Alternatively, the input element 211 and the light source hole 212 are closer to the far end 2120 than the receiving cavity 27.

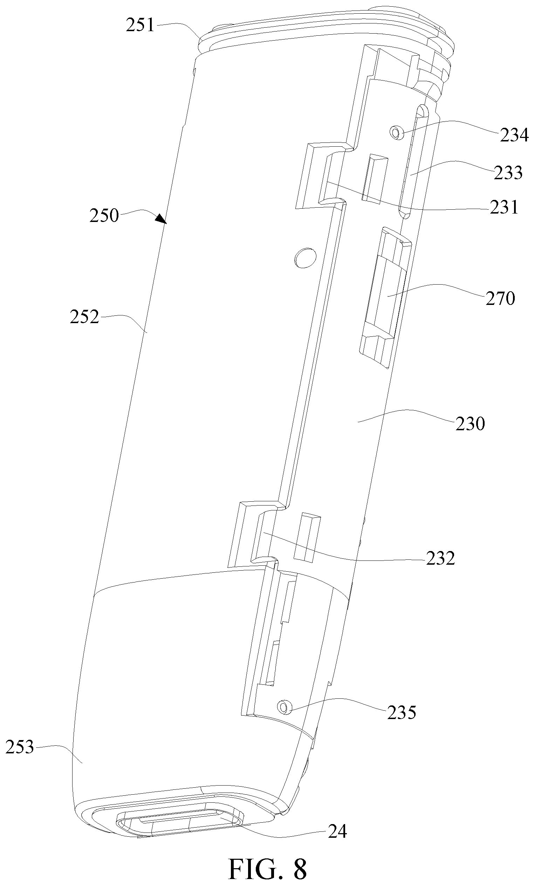

Further, as shown in FIG. 3 to FIG. 8, the power supply mechanism 200 includes:
a battery cell 21, configured to supply power. In this implementation, the battery cell 21 is a direct current battery cell. In an optional embodiment, a direct current supply voltage provided by the battery cell 21 ranges from about 2.5 V to about 9.0 V, and a direct current provided by the battery cell 21 ranges from about 2.5 A to about 20 A. For example, in a specific implementation, a direct current supply voltage provided by the battery cell 21 ranges from 3.5V to about 5.0V.

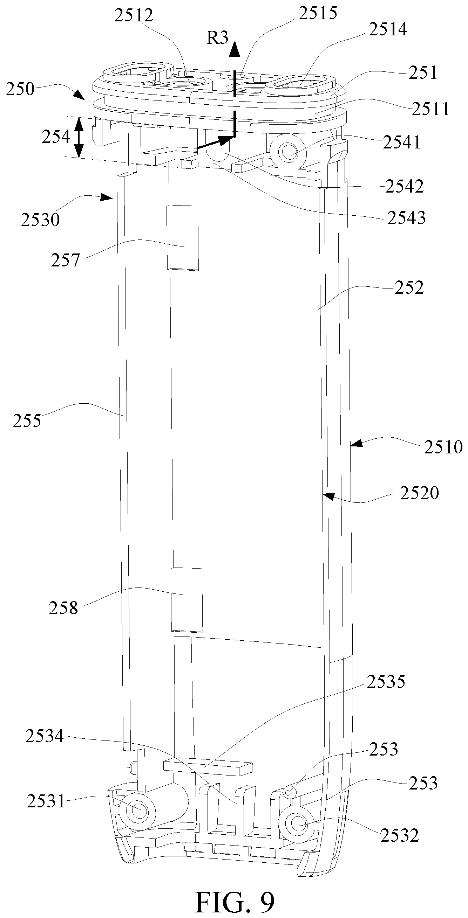

Further, as shown in FIG. 3 to FIG. 9, the power supply mechanism 200 includes:
a support 250, configured to provide a support for the components in the shell 210. The support 250 is configured to be a lengthwise shape extending inside the shell 210 in the length direction of the power supply mechanism 200. The support 250 is moulded by a mouldable material such as an organic polymer. The organic polymer is, for example, various types of plastic (e.g. polycarbonate and PEEK).

The support 250 includes: a first support part 251, a second support part 252, and a third support part 253 which are arranged in sequence in the length direction. The first support part 251 is close to the near end 2110, and the third support part 253 is close to the far end 2120. One side of the second support part 252 facing or close to the front side 2150 and one side of the third support part 253 facing or close to the front side 2150 are provided with openings or are opened. In addition, the first support part 251 is perpendicular to the length direction.

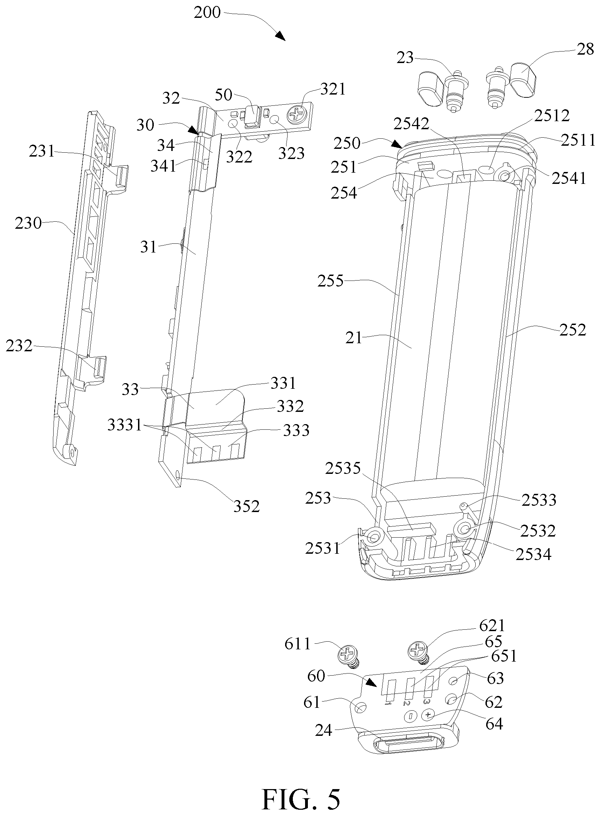

During implementation, the first support part 251 is configured to support and maintain the electrical contact 23. The second support part 252 is configured to at least partially accommodate and maintain the battery cell 21. The third support part 253 is configured to at least partially accommodate and maintain the charging interface 24. In addition, during implementation, the first support part 251 is further configured to support and maintain the seal element 26. Specifically, the seal element 26 may surround or encircle an end surface or a peripheral side surface of the first support part 251 that faces the near end 2110. For example, as shown in FIG. 5, the first support part 251 is provided with a groove 2511 surrounding the first support part 251 in a circumferential direction. During assembling, the seal element 26 may be an annular silicon ring or the like. The first support part 251 is enclosed and sleeved in the groove 2511, to provide sealing between the shell 210 and the first support part 251.

During implementation, the electrical contact 23 is a conductive elastic pin extending in the length direction of the power supply mechanism 200. The electrical contact 23 is at least partially compressible. In addition, the electrical contact 23 is maintained on the first support part 251, so as to be supported by the first support part 251. Alternatively, the support 250 is directly integrally moulded around the electrical contact 23. **In** addition, during implementation, the electrical contact 23 passes through the first support part 251 in the length direction of the power supply mechanism 200. The electrical contact 23 passes through from one side of the first support part 251 facing or close to the near end 2110 to the other side in the length direction of the power supply mechanism 200.

**In** addition, during implementation, the first support part 251 is provided with a contact hole 2512 that passes through from one side of the first support part 251 facing or close to the near end 2110 to the other side, and the electrical contact 23 is at least partially accommodated and maintained in the contact hole 2512. A groove 2514 is further arranged on one side of the first support part 251 facing the near end 2110, to accommodate and maintain a magnetic element 28.

When the atomizer 100 is at least partially received in the receiving cavity 27, the magnetic element 28 is in magnetic attraction with the atomizer 100, so that the atomizer 100 is stably received in the receiving cavity 27. In some embodiments, the magnetic element 28 is, for example, a magnetic body or a magnetic metal that is in magnetic attraction with a magnetic body.

In addition, during implementation, the second support part 252 is opened toward or close to the front side 2150, and the battery cell 21 is at least partially accommodated and maintained in the second support part 252. In addition, during implementation, the third support part 253 is opened toward or close to the front side 2150, and the charging interface 24 is at least partially accommodated and maintained in the second support part 253.

The support 250 is further provided with a partition wall 2535 extending in a direction perpendicular to the length direction, and the second support part 252 and the third support part 253 are separated and defined by the partition wall 2535. The partition wall 2535 has an upper side surface facing the second support part 252 and a lower side surface facing the third support part 253. After assembling, the battery cell 21 abuts against the upper side surface of the partition wall 2535. In addition, the charging interface 24 abuts against the lower side surface of the partition wall 2535.

In addition, the support 250 is further provided with a spacing space 254 defined between the first support part 251 and the second support part 252. The spacing space 254 is configured to partially accommodate and maintain a portion of the circuit board assembly 30. Alternatively, the sensor 50 is mounted or arranged in the spacing space 254.

In addition, further as shown in FIG. 3 to FIG. 9, the power supply mechanism 200 includes:
a charging circuit board 60 which is thin and sheet-like or plate-like. The charging circuit board 60 is, for example, a hard printed circuit board (PCB) or a soft PCB board. The charging interface 24 is directly fixed or fastened on the charging circuit board 60 in a soldered manner or the like.

The charging circuit board 60 is provided with:
a battery cell connection portion 64, which is, for example, a bonding pad or an electrical contact, and is configured to solder a positive electrode/a negative electrode of the battery cell 21 for connection to conduct electricity. The battery cell connection portion 64 is connected to the charging interface 24 through a conductive line printed or arranged on the charging circuit board 60, so that during use, the charging interface 24 is connected to a positive electrode/negative electrode of the battery cell 21 through the conductive line on the charging circuit board 60 to form electrical conduction, to charge the battery cell 21. In addition, during implementation, the battery cell connection portion 64 is located on one side of the charging circuit board 60 facing away from the charging interface 24. The battery cell connection portion 64 has a shape or a color different from that of another portion on a surface of the charging circuit board 60, which is advantageous for being identified and located by a device such as a color sensor or human eyes. For example, in some specific embodiments, the battery cell connection portion 64 is silver or a silver gray, and another portion on the surface of the charging circuit board 60 is green.

The charging circuit board 60 is provided with: a charging integrated circuit (IC), for example, a common L4066 charging IC, a charging IC (SimTech), a CV1055P charging IC, an S083 charging IC prepared by using a single ASIC, and the like. The charging IC is configured to monitor and control charging on the battery cell 21.

Further, after assembling, the charging circuit board 60 is maintained at the third support part 253 of the support 250. Moreover, after assembling, the charging interface 24 is covered or blocked by the charging circuit board 60 at the opening of the third support part 253.

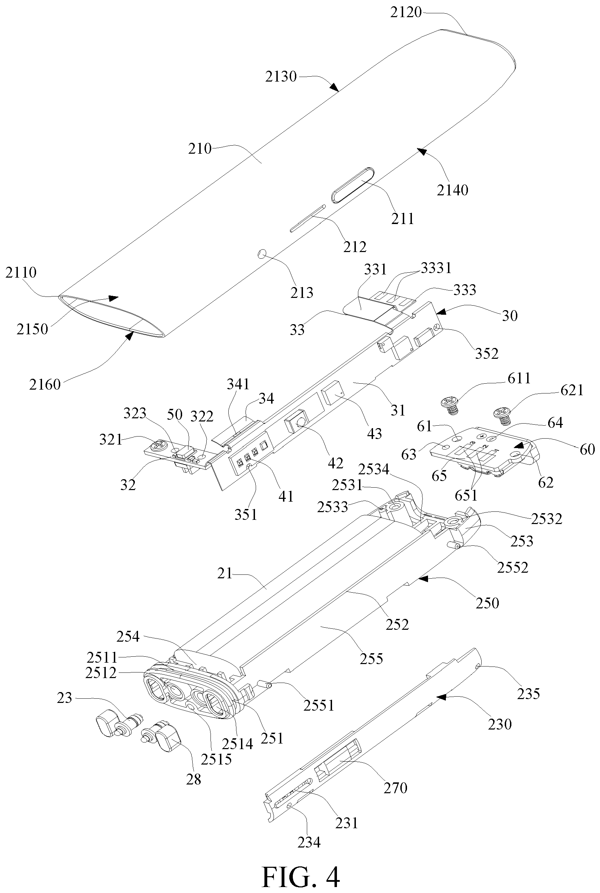

In some other implementations, the charging circuit board 60 is fastened to the third support part 253 through a fastening component. For example, in specific implementations of FIG. 4 to FIG. 8, a screw base 2531 and a screw seat 2532 are arranged on the third support part 253 of the support 250. The charging circuit board 60 is provided with a screw hole 61 and a screw hole 62. During assembling, a screw 611 is connected to the screw seat 2531 through the screw hole 61, and a screw 621 is connected to the screw seat 2532 through the screw hole 62, so as to fasten the charging circuit board 60 to the third support part 253 of the support 250.

The charging circuit board 60 is further provided with:
a positioning hole 63, arranged away from a center of the charging circuit board 60, to position the charging circuit board 60 during assembling. A positioning convex post 2533 is arranged on the third support part 253. During assembling, the positioning convex post 2533 passes through the positioning hole 63 of the charging circuit board 60 for positioning during assembling. In addition, during implementation, a plurality of convex teeth 2534 are further arranged on the third support part 253, to allow the charging interface 24 to abut against for being stopped when the charging interface 24 is accommodated in the third support part 253 by the opening. The plurality of convex teeth 2534 are parallel to each other or away from each other.

In addition, further, as shown in FIG. 4 to FIG. 8, the charging circuit board 60 is provided with:
a circuit connection portion 65, ,which is, for example, a bonding pad or an electrical contact, and is configured to be connected to the circuit board assembly 30. For example, in FIG. 4 to FIG. 8, the circuit connection portion 65 includes a plurality of bonding pads 651, so that the circuit board assembly 30 is soldered on the bonding pads 651 to form an electrical connection to the charging circuit board 60. In addition, the circuit connection portion 65 is far away from the far end 2120. In addition, the circuit connection portion 65 is arranged on one side of the charging circuit board 60 facing away from the charging interface 24. Similarly, the circuit connection portion 65 also has a shape and/or a color different from that of the charging circuit board 60 and/or that of the battery cell connection portion 64. For example, in a specific embodiment, the circuit connection portion 65 is rectangular and gold or golden yellow. The battery cell connection portion 64 is basically silver and round, which is advantageous for being identified and positioned by a device or human eyes.

In some embodiments, the power supply mechanism 200 includes a charging assembly. The charging assembly includes the charging circuit board 60, the charging interface 24, the battery cell connection portion 64, and the circuit connection portion 65. The charging assembly is configured to charge the battery cell 21.

In addition, further, as shown in FIG. 4 to FIG. 8 and FIG. 10, the power supply mechanism 200 further includes:
the circuit board assembly 30, configured to control operations of the power supply mechanism 200. The circuit board assembly 30 includes:
a first portion 31, extending in the length direction of the power supply mechanism 200. In addition, the first portion 31 is close to the second side 2140 in the width direction. The first portion 31 is parallel to the length direction and the thickness direction, and perpendicular to the width direction.

In addition, the first portion 31 is configured to be located between the battery cell 21 and the second side 2140 in the width direction of the power supply mechanism 200. In addition, the first portion 31 is substantially adjacent or close to the second side 2140, and is at least closer to the second side 2140 than the battery cell 21. In addition, an extension dimension of the first portion 31 in the length direction of the power supply mechanism 200 is greater than an extension dimension of the battery cell 21 in the length direction of the power supply mechanism 200. Alternatively, an extension length of the first portion 31 is greater than a length of the battery cell 21. For example, in some embodiments, an extension length of the first portion 31 is greater than a length of the battery cell 21 by 5 mm to 15 mm.

A light source 41 is arranged on a surface of the first portion 31 close to or facing the second side 2140. One or more light sources 41 may be included. A plurality of light sources 41 are arranged in sequence in a length direction of the first portion 31.

Moreover, an MCU controller 43 is further arranged on the surface of the first portion 31 close to or facing the second side 2140. The MCU controller 43 is configured to control, according to a sensing result of the sensor 50, the power supply mechanism 200 to output power to the atomizer 100.

Moreover, the MCU controller 43 is further configured to obtain a positive electrode voltage or an output voltage of the battery cell 21, to determine a charge level or a battery level of the battery cell 21. In addition, the MCU controller 43 is configured to:
when the positive electrode voltage or the output voltage of the battery cell 21 is greater than a first threshold, control all the plurality of light sources 41 to emit light, to prompt a user that a battery level of the battery cell 21 is at a relatively full or sufficient first level; and
when the positive electrode voltage or the output voltage of the battery cell 21 is less than a second threshold, control only one of the plurality of light sources 41 to be turned on and emit light, to prompt a user that the battery level of the battery cell 21 is at a relatively low second level; and
when the positive electrode voltage or the output voltage of the battery cell 21 is less than the first threshold and is greater than the second threshold, control a quantity of light sources that emit light among the plurality of light sources 41 to be greater than one and less than a total quantity of the light sources 41, to prompt a user that the battery level of the battery cell 21 is at a third level that is lower than the first level and higher than the second level.

In addition, an input response unit 42 is further arranged on the surface of the first portion 31 close to or facing the second side 2140, to generate an electrical signal such as a high-level signal in response to or according to an operation performed by the user using the input element 211. The power supply mechanism 200 determines, according to the electrical signal, the operation performed by the user using the input element 211, to lock or unlock the power supply mechanism 200. In some implementations, the input response unit 42 is a common button switch circuit, and can generate an input electrical signal in response to or according to a pressing operation performed by a user on the input element 211.

In addition, the input response unit 42 is located between the light sources 41 and the MCU controller 43.

Moreover, for mounting and fixing of the first portion 31, referring to FIG. 4 to FIG. 9, the support part 250 of the support 250 has a retaining wall 255 extending flatly and straightly in the length direction. The retaining wall 255 is parallel to the length direction and the thickness direction, and perpendicular to the width direction. Alternatively, the retaining wall 255 that extends flatly and straightly is parallel to the first portion 31. During implementation, the retaining wall 255 defines a circuit mounting space 2530 of the support 250 close to the second side 2140. The first portion 31 is mounted in the circuit mounting space 2530 and abuts against or bonded to a surface of the retaining wall 255 exposed in the circuit mounting space 2530.

Moreover, in some embodiments, the retaining wall 255 is closer to the second side 2140 and away from the first side 2130. For example, during implementation, a distance between the retaining wall 255 and the second side 2140 is about 5 mm to 10 mm, and a distance between the retaining wall 255 and the first side 2130 is about 10 mm to 20 mm.

During implementation, the second support part 252 is separated by the retaining wall 255 into a battery cell assembling space for accommodating the battery cell 21, and a circuit mounting space 2530 at least partially for mounting and accommodating the circuit board assembly 30 and/or the first portion 31, and the battery cell assembling space and the circuit mounting space 2530 are located on two sides of the retaining wall 255. In addition, the battery cell assembling space is located between the retaining wall 255 and the first side 2130, and the circuit mounting space 2530 is located between the retaining wall 255 and the second side 2140. In addition, apparently, a volume of the battery cell assembling space is greater than a volume of the circuit mounting space 2530.

For fixing and assembling of the first portion 31, the power supply mechanism 200 further includes:
a fastening component 230. The fastening component 230 is adjacent to the second side 2140.

The fastening component 230 clamps or fastens the first portion 31 to the retaining wall 255 of the support 250 and/or the circuit mounting space 2530 from the second side 2140.

The fastening component 230 is moulded by a mouldable material such as plastic including a polycarbonate, ceramic, and metal.

The fastening component 230 extends lengthwise in the length direction of the power supply mechanism 200, and has an extension length of about 12 mm to 18 mm. An extension length of the fastening component 230 is substantially equal to an extension length of the first portion 31.

A hook 231 and a hook 232 are arranged on one side of the fastening component 230 adjacent to the rear side 2160. The hook 231 and the hook 232 are spaced apart in the length direction of the fastening component 230. Correspondingly, a clamping slot 257 matched with the hook 231 and a clamping slot 258 matched with the hook 232 are arranged on one side of the support 250 adjacent to the rear side 2160, so that the fastening component 230 is in fastened connection with the support 250. After assembling, the fastening component 230 is accommodated and maintained in the circuit mounting space 2530.

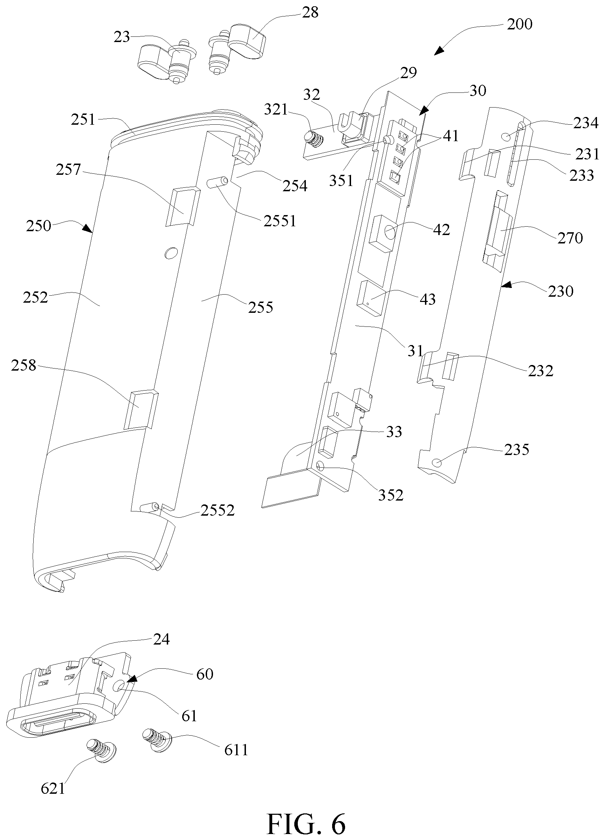

Further as shown in FIG. 6, a convex post 2551 and a convex post 2552 that extend toward the second side 2140 are arranged on the retaining wall 255. The first portion 31 has a hole 351 for the convex post 2551 to pass through, and a hole 352 for the convex post 2552 to pass through. A hole 234 for the convex post 2551 to pass through and a hole 235 for the convex post 2552 to pass through are provided in the fastening component 230. After assembling, it is advantageous for positioning during assembling through the cooperation between the convex post 2551 and the holes 351 and 234, and the cooperation between the convex post 2552 and the holes 352 and 235.

Further, the fastening component 230 is further provided with a light channel 233 which is opposite to the light source 41 and the light source hole 212, and located between the light source 41 and the light source hole 212, so as to provide an illumination path through which light emitted by the light source 41 is irradiated or transmitted to the light source hole 212.

Further, the fastening component 230 is further provided with a transmission element 270. It is located between the input element 211 and the input response unit 42, to transmit an operation performed by a user on the input element 211 to the input response unit 42. For example, the transmission element 270 is a movable component, and can be pressed or operated by the user to perform activation on the input element 211, thereby transmitting a pressure of the user to the input response unit 42.

Further, as shown in FIG. 4 to FIG. 8 and FIG. 10, the circuit board assembly 30 further includes:
a second portion 32, extending from the first portion 31 toward the first side 2130 in the width direction.

Moreover, the second portion 32 is arranged at an end portion of the first portion 31 close to or facing the near end 2110.

In addition, the second portion 32 is thin and sheet-like or plate-like. The second portion 32 is parallel to the length direction and the width direction, and perpendicular to the thickness direction.

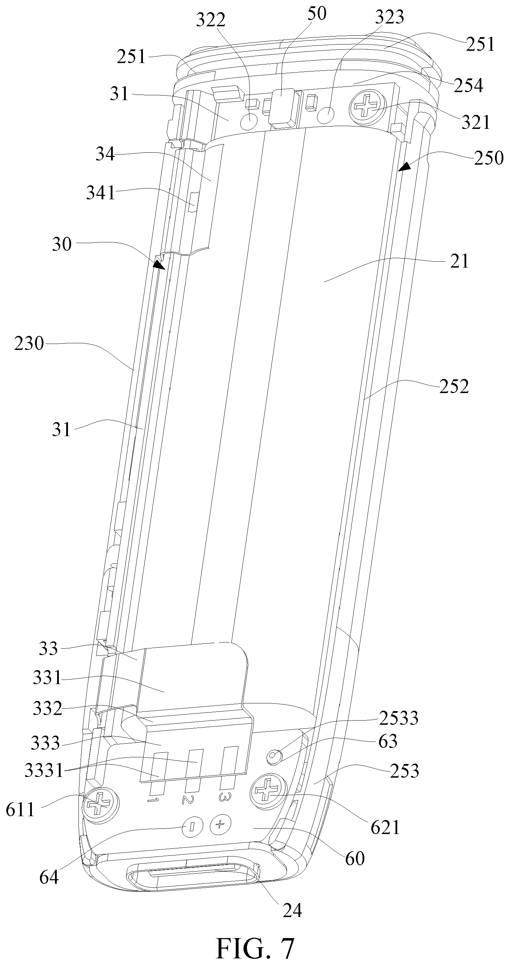

After assembling, the second portion 32 is located in the spacing space 254 between the first support part 251 and the second support part 252. The spacing space 254 is opened close to the front side 2150 of the power supply mechanism 200, and the spacing space 254 is closed close to the rear side 2160 of the power supply mechanism 200. After assembling, the second portion 32 is close to the front side 2150. Alternatively, the second portion 32 extends from an opening of the spacing space 254 close to the front side 2150 or is mounted in the spacing space 254. Namely, after assembling, the second portion 32 and the opening defined by the second support part 252 are located on the same side. Specifically, as shown in FIG. 5 and FIG. 7, after penetrating through the second portion 32 in the thickness direction through a fastener such as a screw 321, the second portion 32 is connected to the screw seat 2541 of the support 250 arranged in the spacing space 254, to connect and fasten the second portion 32 to the support 250. After assembling, the fastener such as the screw 32 or a hole such as a screw hole penetrating through the second portion 32 is far away from or faces away from the first portion 31. Moreover, after assembling, the second portion 32 abuts against the screw seat 2541.

Alternatively, in some other changed embodiments, any one of the second portion 32, the third portion 33, and the fourth portion 34 is arranged on two sides of a width of the first portion 31 relative to the other two portions. Alternatively, one of the second portion 32, the third portion 33, and the fourth portion 34 is close to or located on the front side 2150, and the other two portions are close to the rear side 2160.

The second portion 32 is located at an end portion of the first portion 31 close to or facing the near end 2110. Alternatively, the second portion 32 is formed by the end portion, extending in the width direction, of the first portion 311 close to or facing the near end 2110.

The sensor 50 is arranged on the second portion 32. Specifically, as shown in FIG. 5 and FIG. 7, the sensor 50 is arranged on the surface of the second portion 32 close to or facing the front side 2150.

The second portion 32 is further provided with a contact connection portion 322 and a contact connection portion 323, such as a bonding pad or a contact pad. A region of the contact connection portion 322 and the contact connection portion 323 is identified by a graphic or a pattern printed or formed on the surface of the second portion 32, to facilitate identification and positioning. For example, during implementation, the contact connection portion 322 and the contact connection portion 323 are defined by a white circle pattern printed on the surface of the second portion 32, or a pattern or graphics with another identifiable color, so as to prompt a device or a producer to solder or connect the electrical contact 23 in the contact connection portion 322 and the contact connection portion 323 that are defined by the white circle. Each of the contact connection portion 322 and the contact connection portion 323 that are defined by the white circle has a diameter of about 3 mm to 6 mm.

During implementation, the second portion 32 is provided with a conductive line that is formed by printing or the like, so as to electrically connect the contact connection portion 322, the contact connection portion 323, the sensor 50, and the like to the first portion 31 and/or the MCU controller 43.

The contact connection portion 322 and the contact connection portion 323 are respectively arranged on two sides of the sensor 50. Alternatively, the sensor 50 is located between the contact connection portion 322 and the contact connection portion 323. In addition, during implementation, the circuit board assembly 30 is connected to the electrical contact 23 through the second portion 32, thereby supplying power to or outputting power to the atomizer 100. In addition, during implementation, the MCU controller 43 controls, by using the sensing result of the sensor 50 arranged on the second portion 32, power to be supplied or output to the atomizer 100.

Further, as shown in FIG. 4 to FIG. 8 and FIG. 10, the circuit board assembly 30 further includes:
a third portion 33, extending from the first portion 31 toward the first side 2130 in the width direction.

Moreover, the third portion 33 is arranged at an end portion of the first portion 31 close to or facing the far end 2120.

In addition, the third portion 33 is thin and sheet-like or plate-like. The third portion 33 is parallel to the length direction and the width direction, and perpendicular to the thickness direction.

The third portion 33 is configured to electrically connect the first portion 31 to the charging circuit board 60.

As shown in FIG. 7, the third portion 33 includes:
a section 331, abutting against or bonded to a surface of the battery cell 21;
a section 333, abutting against or bonded to the charging circuit board 60 and connected to the circuit connection portion 65 for conduction, where during implementation, a plurality of bonding pads 3331 are arranged on the section 333, so as to be soldered to the bonding pads 651 on the circuit connection portion 65, thereby achieving a conductive connection between the charging circuit board 60 and the circuit board assembly 30; after connection, the battery cell 21 supplies power to the circuit board assembly 30; and
a section 332, located between the section 331 and the section 333.

Further, as shown in FIG. 4 to FIG. 8 and FIG. 10, the circuit board assembly 30 further includes:
a fourth portion 34, extending from the first portion 31 toward the first side 2130 in the width direction; and
a temperature sensor 341, arranged on or bonded to the fourth portion 34 and adjacent to the battery cell 21, to sense a temperature of the battery cell 21.

Correspondingly, the temperature sensor 341 is connected to the MCU controller 43 through conductive lines formed on the first portion 31 and the fourth portion 34. During implementation, the MCU controller 43 may obtain or monitor a sensing result of the temperature sensor 341. Moreover, the MCU controller 43 is configured to prevent or reduce the electric power output by the battery cell 21 to another component and/or the circuit board assembly 30 and/or the atomizer 100 when the temperature of the battery cell 21 sensed by the temperature sensor 341 is greater than a preset threshold.

In some embodiments, the temperature sensor 341 may be a thermistor type temperature sensor such as a PT1000 temperature sensor, or a thermocouple type temperature sensor. Alternatively, the temperature sensor 341 is a thermistor, such as a thermistor with a positive resistance temperature coefficient or a thermistor with a negative resistance temperature coefficient. Moreover, the thermistor is combined with or adjacent to the battery cell 21, so that the MCU controller 43 can determine a temperature of the battery cell 21 by sampling or obtaining an electrical characteristic such as a resistance or a voltage of the thermistor, so that the MCU controller 43 reduces or prevents the battery cell 21 from outputting electric power when the electrical characteristic of the thermistor exceeds a preset threshold.

During implementation, an extension dimension of the fourth portion 34 in the width direction of the power supply mechanism 200 is less than an extension dimension of the third portion 33 in the width direction of the power supply mechanism 200. Moreover, an extension dimension of the third portion 33 in the width direction of the power supply mechanism 200 is less than an extension dimension of the second portion 32 in the width direction of the power supply mechanism 200.

During implementation, the temperature sensor 341 is combined with or arranged on a surface of the fourth portion 34 facing away from the battery cell 21. Moreover, a surface of the fourth portion 34 facing or combined with the battery cell 21 is smooth. Moreover, the surface of the fourth portion 34 facing or combined with the battery cell 21 does not include an electronic device such as a resistor, a capacitor, and a chip.

The second portion 32, the third portion 33, and the fourth portion 34 are located on the same side of the first portion 31. For example, the second portion 32, the third portion 33, and the fourth portion 34 are all arranged on one side of the first portion 31 close to the rear side 2160.

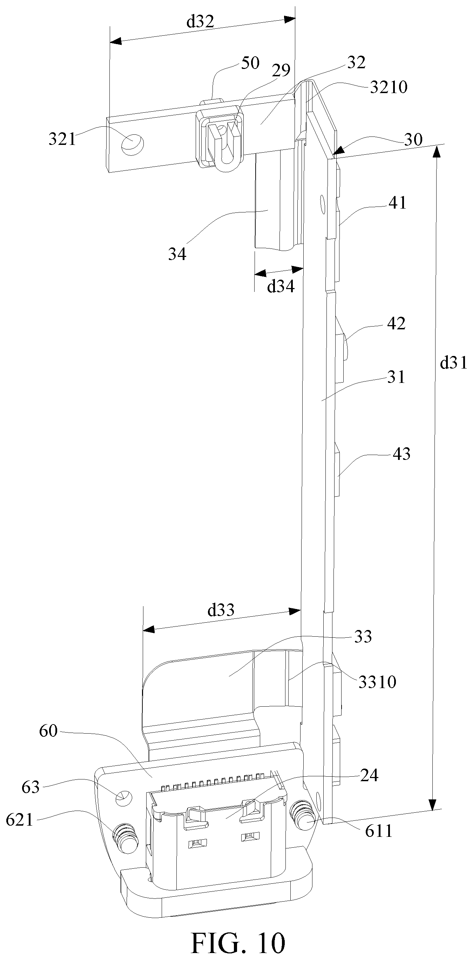

Further, as shown in FIG. 10, an extension dimension d31 of the first portion 31 in the length direction of the power supply mechanism 200 is about 40 mm to 60 mm. A width dimension of the first portion 31 is about between 4 mm and 10 mm. A thickness dimension of the first portion 31 is about between 0.4 mm and 1.2 mm.

Further, as shown in FIG. 10, an extension dimension d32 of the second portion 32 in the width direction of the power supply mechanism 200 is about between 10 mm and 18 mm. A width dimension of the second portion 32 is about between 2 mm and 5 mm. The thickness dimension of the first portion 31 is about between 0.5 mm to 1.5mm.

Further, as shown in FIG. 10, an extension dimension d33 of the third portion 33 in the width direction of the power supply mechanism 200 is about between 6 mm and 12 mm. A thickness dimension of the third portion 33 is about between 0.5 mm and 1.5 mm.

Further, as shown in FIG. 10, an extension dimension d34 of the fourth portion 34 in the width direction of the power supply mechanism 200 is about between 3 mm and 8 mm.

In addition, during implementation, the second portion 32 and/or the third portion 33 and/or the fourth portion 34 are/is basically perpendicular to the first portion 31. The second portion 32, the third portion 33, and the fourth portion 34 are basically parallel to each other.

In addition, in the length direction of the power supply mechanism 200, the fourth portion 34 is located between the second portion 32 and the third portion 33.

Further, as shown in FIG. 10, a surface, facing or close to the battery cell 21, of the first portion 31 of the circuit board assembly 30 is smooth. Alternatively, the light source 41, the MCU controller 43, or an electronic device such as a resistor or a capacitor is located only on the surface of the first portion 31 facing or close to the second side 2140, so that the surface of the first portion 31 facing or close to the second side 2140 is bumpy. Moreover, the surface of the first portion 31 facing or close to the battery cell 21 is not provided with an electronic device such as a resistor or a capacitor.

In some implementations, the first portion 31 and/or the second portion 32 and/or the third portion 33 and/or the fourth portion 34 of the circuit board assembly 30 includes one or more layers. In some implementations, the one or more layers may include at least one of a polyimide layer, a polytetrafluoroethylene layer, a polycarbonate layer, a polyester layer, an aluminum foil layer, a stainless steel layer, and the like.

In some embodiments, one or more layers in the first portion 31 and/or the second portion 32 and/or the third portion 33 and/or the fourth portion 34 are soft. Alternatively, in some implementations, one or more layers in the first portion 31 and/or the second portion 32 and/or the third portion 33 and/or the fourth portion 34 are hard.

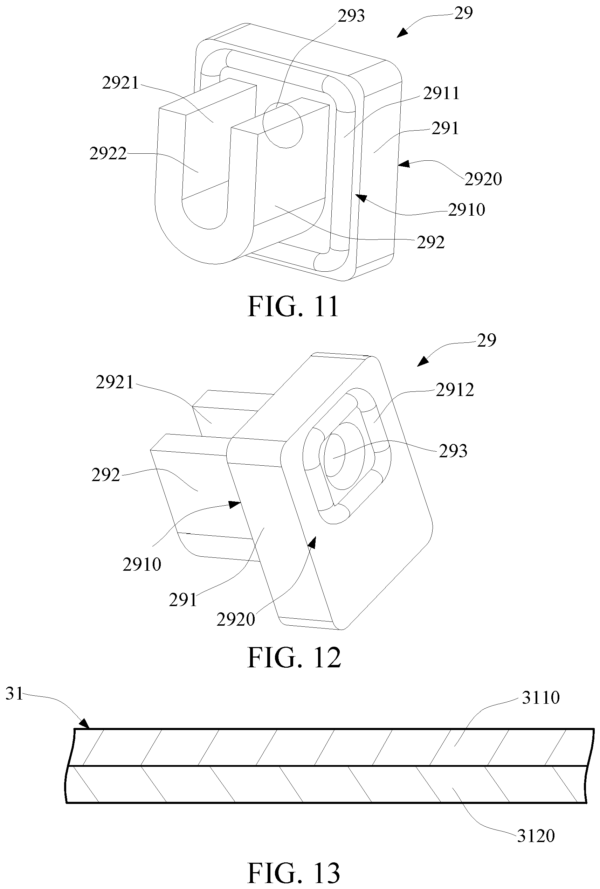

For example, FIG. 13 is a schematic cross-sectional diagram of a first portion 31 in an embodiment. The first portion 31 includes at least two layers. Specifically: a soft substrate layer 3110 and a hard substrate layer 3120. Moreover, the light source 41, the MCU controller 43, the conductive line, the electronic device, and the like are all combined on a surface of the soft substrate layer 3110. Where:
The soft substrate layer 3110 is a flexible organic polymer layer such as a polyimide layer.

The hard substrate layer 3120 is, for example, stainless steel, an aluminum foil, or an organic polymer such as polytetrafluoroethylene or polycarbonate.

In some embodiments, one or more layers in the first portion 31 and/or the second portion 32 and/or the third portion 33 and/or the fourth portion 34 are adhered through a thermosetting adhesive. In some specific embodiments, the thermosetting adhesive includes an epoxy adhesive. For example, in some implementations, after a surface of the hard substrate layer 3120 is covered with a liquid epoxy adhesive, the soft substrate layer 3110 then covers the surface of the hard substrate layer 3120, and the epoxy adhesive is heated to be solidified, so that the soft substrate layer 3110 and the hard substrate layer 3120 are adhered and fastened.

In some embodiments, hardness of the hard substrate layer 3120 in the first portion 31 is greater than hardness of one or more layers in the second portion 32 and/or the third portion 33 and/or the fourth portion 34.

Alternatively, in some other embodiments, in some embodiments, hardness of the first portion 31 is greater than hardness of the second portion 32 and/or the third portion 33 and/or the fourth portion 34. Alternatively, in some embodiments, the first portion 31 is hard. Alternatively, the first portion 31 includes a stainless steel substrate layer 3120. The second portion 32 and/or the third portion 33 and/or the fourth portion 34 are/is soft, and the second portion 32 and/or the third portion 33 and/or the fourth portion 34 may include only one or more organic polymer layers.

Alternatively, in some other changed embodiments, the first portion 31 and/or the second portion 32 and/or the third portion 33 and/or the fourth portion 34 are/is formed by bending an organic polymer layer. For example, in some embodiments, the first portion 31 and/or the second portion 32 and/or the third portion 33 and/or the fourth portion 34 are/is formed by bending a bendable sheet-like matrix, such as a polyimide sheet, a thin film, or a stainless steel sheet.

Alternatively, in some other changed embodiments, the first portion 31 and/or the second portion 32 and/or the third portion 33 and/or the fourth portion 34 are/is connected to each other after being separately prepared or obtained. For example:
The first portion 31 includes a first circuit board which may be a soft flexible printed circuit (FPC) board or a hard printed circuit board (PCB).
The second portion 32 includes a second circuit board which may be a soft FPC board or a hard PCB.
The third portion 33 includes a third circuit board which may be a soft FPC board or a hard PCB.

The first circuit board, the second circuit board, and the third circuit board are independently prepared and obtained. The second circuit board including the second portion 32 is connected to the first circuit board of the first portion 31 through a flat flexible cable 3210. The third circuit board including the third portion 33 is connected to the first circuit board of the first portion 31 through a flat flexible cable 3310.

After assembling, the charging interface 24 and the third portion 33 are respectively connected to the charging circuit board 60 on two surfaces of the charging circuit board 60 back on to each other.

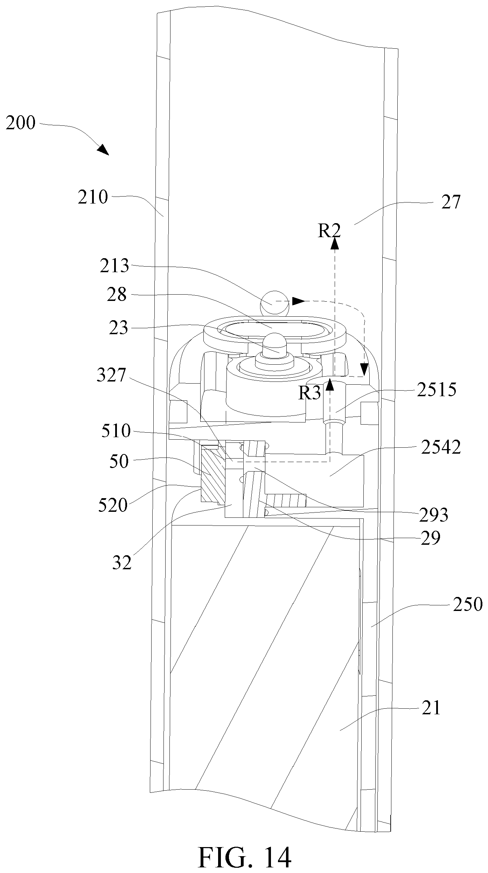

Further, as shown in FIG. 7, FIG. 9 to FIG. 12, and FIG. 14, the sensor 50 is also constructed into a cube. In some specific embodiments, the sensor 50 has a length of about 2 mm to 3.5 mm, a width of about 1.5 mm to 2.5 mm, and a thickness of about 0.6 mm to 1.4 mm. A volume of the sensor 50 is less than 12 mm3. In this implementation, the sensor 50 includes:
a first sensing surface 510, which is in airflow communication with the air inlet 213 after assembling and is then configured to sense a pressure caused by an airflow flowing through the electronic atomization device during inhalation of a user; and
a second sensing surface 520, which is isolated from the airflow flowing through the electronic atomization device during the inhalation of the user, where the second sensing surface 520 is exposed in the spacing space 254, and the spacing space 254 is communicated with environmental atmosphere through an assembling void or gap in the power supply mechanism 200. During use, the second sensing surface 520 is configured to sense an environmental atmospheric pressure.

The sensor 50 is configured to convert a difference between a pressure sensed by the first sensing surface 510 and a pressure sensed by the second sensing surface 520 into a corresponding voltage signal. Namely, the sensor 50 is configured to generate a voltage signal corresponding to a pressure difference between the environmental atmospheric pressure and the pressure caused by the airflow flowing through the electronic atomization device during the inhalation of the user.

In some specific embodiments, the sensor 50 is a micro electro mechanical system (MEMS)-based sensor. This type of sensor 50 can generate, by sensing pressures in different directions, voltage signals reflecting their pressure differences. During implementation, the first sensing surface 510 and the second sensing surface 520 face away from each other in a thickness direction of the sensor 50. In some implementations, a magnitude of the voltage signal is linear or proportional to a magnitude of the pressure difference.

The MCU controller 43 controls, based on the voltage signal generated by the sensor 50, the battery cell 21 to output power to the atomizer 100. For example, in an embodiment, the MCU controller 43 controls, when the voltage signal generated by the sensor 50 is greater than a preset threshold, the battery cell 21 to output power to the atomizer 100. Alternatively, for example, in another embodiment, the MCU controller 43 controls, based on the voltage signal generated by the sensor 50, the battery cell 21 to output power related to the magnitude of the voltage signal to the atomizer 100. For example, if the voltage signal is greater, the power output by the battery cell 21 controlled by the MCU controller 43 to the atomizer 100 is higher. If the voltage signal is less, the power output by the battery cell 21 controlled by the MCU controller 43 to the atomizer 100 is lower.

Specifically, The design of an air path for pressure sensing of the sensor 50 is shown in FIG. 7, FIG. 9 to FIG. 12, and FIG. 14. A first air hole 327 penetrating through the second portion 32, and a first channel portion 2542 and a second channel portion 2515 that are defined by the support 250 performs airflow communication between the first sensing surface 510 of the sensor 50 and the receiving cavity 27, to sense the pressure of the airflow during the inhalation of the user, for example, as shown by arrow R3 in FIG. 4. Specifically:
The first air hole 327 penetrates from one side of the second portion 32 facing the front side 2150 to the other side of the second portion 32 facing the rear side 2160. The first sensing surface 510 of the sensor 50 is combined to one side of the second portion 32 adjacent to or facing the front side 2150.
The second channel portion 2515 is defined on the first support part 251 of the support 250, and extends away from the receiving cavity 27 from a surface of the first support part 251 adjacent to or facing the receiving cavity 27. Moreover, the second channel portion 2515 deviates from a central axis of the power supply mechanism 200. For example, the second channel portion 2515 is close to the rear side 2160. A port of the second channel portion 2515 facing or adjacent to the receiving cavity 27 is exposed. The first channel portion 2542 is defined by an annular wall 2543 located in the spacing space 254. Namely, the first channel portion 2542 is defined in the spacing space 254 of the support 250, and the first channel portion 2542 extends from the second channel portion 2515 toward the front side 2150 in the thickness direction of the power supply mechanism 200. In addition, the first channel portion 2542 communicates with the first air hole 327.

In some implementations, a cross-sectional area of the first channel portion 2542 is larger than a cross-sectional area of the second channel portion 2515. The first channel portion 2542 is perpendicular to the second channel portion 2515. In addition, in some embodiments, the first channel portion 2542 is located between the battery cell 21 and the first support part 251.

In some embodiments, the electronic atomization device includes an air channel. The air channel includes a first channel portion 2542 and a second channel portion 2515.

Further, as shown in FIG. 7, FIG. 9 to FIG. 12, and FIG. 14, between the second portion 32 and a wall 2543 for defining the first channel portion 2542, there is:
a seal element 29, to provide sealing between the second portion 32 and the first channel portion 2542/wall 2543 of the support 250. The seal element 29 is made of a soft material such as silicone. Specifically, the seal element 29 includes: a base portion 291 basically extending flatly and straightly, and an extension portion 292 extending out of one side of the base portion 291. Where:
The base portion 291 is basically a sheet or the like. The base portion 291 has a first surface 2910 and a second surface 2920 that face away from each other. The extension portion 292 extends in a manner that the second surface 2920 faces away from the first surface 2910.

Moreover, the extension portion 292 protrudes out of the base portion 291.

The base portion 291 is provided with a second air hole 293 which penetrates from the first surface 2910 to the second surface 2920.

After assembling, the first surface 2910 of the base portion 291 abuts against or is bonded to the wall 2543 for defining the first channel portion 2542. The second surface 2920 abuts against or is bonded to the second portion 32. Then, after assembling, the base portion 291 provides airtight sealing between the second portion 32 and the wall 2543. The second air hole 293 is aligned with the first air hole 327 in the second portion 32. The second air hole 293 and the first air hole 327 together provide a communication path between the first sensing surface 510 of the sensor 50 and the first channel portion 2542.

During assembling, the extension portion 292 at least partially extends into the first channel portion 2542 defined by the wall 2543, which is advantageous for assembling and positioning.

During assembling, the extension portion 292 is substantially U-shaped or has a U-shaped cross section. An opening 2922 is formed in one side of the extension portion 292 facing away from the base portion 291, and an opening 2921 is also formed in one side of the extension portion 292 close to the first support part 251 of the support 250. Moreover, the extension portion 292 is arranged around a portion of the second air hole 293.

After assembling, the base portion 291 is at least partially pressed or compressed between the second portion 32 and the wall 2543, which is advantageous for improving the airtightness.

As shown in FIG. 11 and FIG. 12, at least one first convex rib 2911 having a closed ring shape is arranged on the first surface 2910 of the base portion 291, and the first convex rib 2911 surrounds the extension portion 292 and/or the second air hole 293 and/or the first channel portion 2542. At least one second convex rib 2912 having a closed ring shape is arranged on the second surface 2920 of the base portion 291, and the second convex rib 2912 surrounds the second air hole 293 and/or the first air hole 327.

During implementation, the second air hole 293 deviates from the center of the base portion 291. For example, as shown in FIG. 11 and FIG. 12, the second air hole 293 is closer to the opening 2921.

After assembling, the second convex rib 2912 abuts against a surface of the second portion 32. The first convex rib 2911 abuts against the wall 2543 of the first channel portion 2542. An interference fit region of the base portion 291 of the seal element 29 formed by the first convex rib 2911 and the second convex rib 2912 is advantageous for improving the airtightness.

Further, the second sensing surface 520 of the sensor 50 is exposed. Specifically, the second sensing surface 520 is exposed in the spacing space 254, and then is communicated with an external environmental atmosphere through a gap or an assembling gap in the power supply mechanism 200.

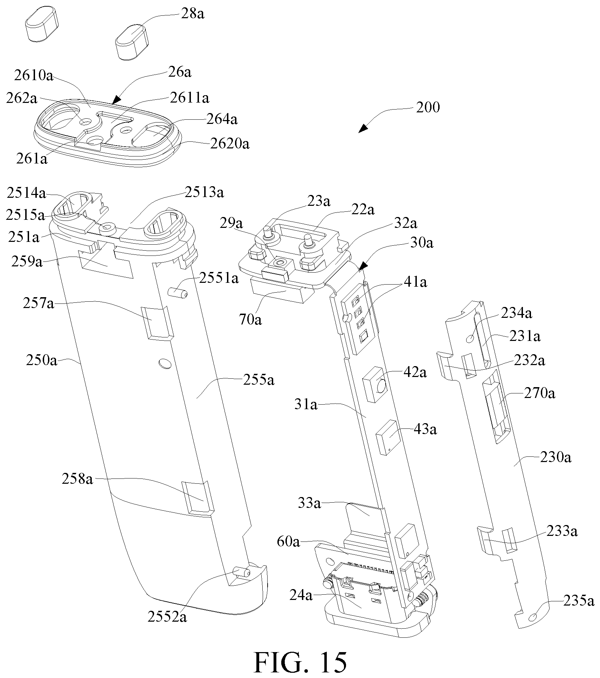

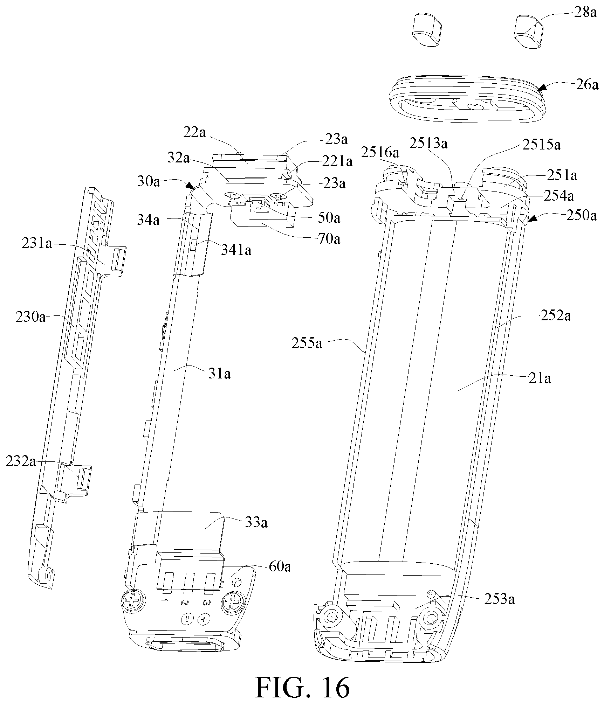

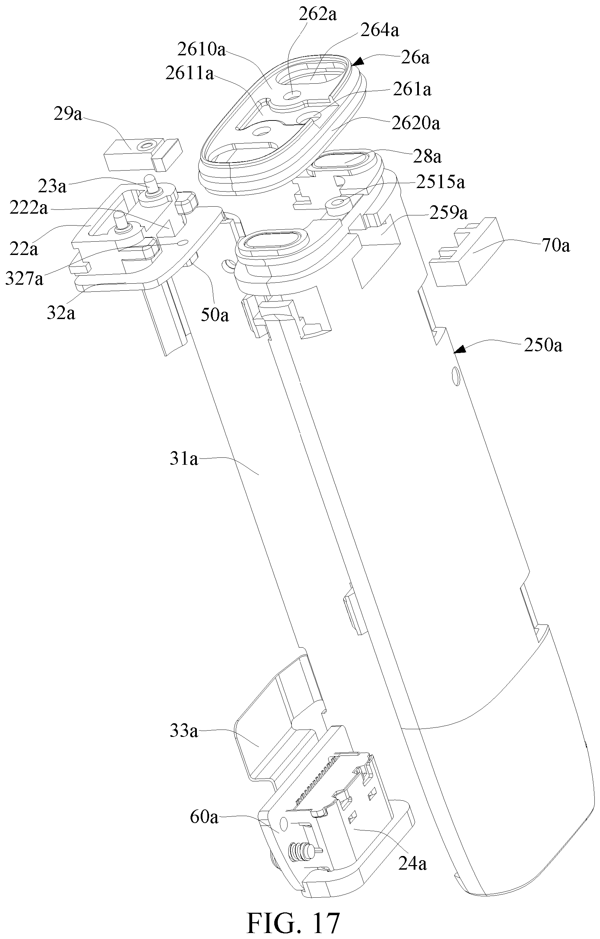

Further, FIG. 15 to FIG. 17 are schematic diagrams of a power supply mechanism 200 according to another embodiment. As shown in FIG. 15 to FIG. 17, a second portion 32a extending from a first portion 31a is parallel to a width direction and a thickness direction of the power supply mechanism 200 and perpendicular to a length direction of the power supply mechanism 200. The second portion 32a has an upper side and a lower side that face away from each other in the thickness direction. A first sensing surface 510a of a sensor 50a is arranged on or combined with a lower side surface of the second portion 32a.

In this embodiment, an upper side surface of the second portion 32a is arranged or provided with a contact assembly, including: an electrical contact 23a, and a contact holder 22a moulded around the electrical contact 23a by a mouldable material such as plastic. The electrical contact 23a is integrated with the contact holder 22a, and the contact holder 22a directly surrounds and maintains the electrical contact 23a.

In this embodiment, the electrical contact 23a penetrates through the contact holder 22a in the length direction of the power supply mechanism 200. In addition, the electrical contact 23a is partially exposed out of an upper side surface of the contact holder 22a, and the electrical contact 23a further partially passes through to a lower side surface of the contact holder 22a.

During assembling, the portion of the electrical contact 23a passing through to the lower side surface of the contact holder 22a further penetrates from an upper side of the second portion 32a to a lower side of the second portion 32a, and is soldered on the lower side surface of the second portion 32a through a soldering material such as soldering tin, thereby forming an electrical connection to the second portion 32a.

Correspondingly, a first support part 251a of the support 250a defines a side opening 2513a facing or close to the front side 2150. During assembling, the contact holder 22a is accommodated and maintained in the side opening 2513a, so that the contact holder 22a is combined with or fastened to the first support part 251a of the support 250a. Specifically, the contact holder 22a is provided with one or more clamping projections 221a surrounding the contact holder 22a. A clamping slot 2516a is provided in an inner wall of the side opening 2513a of the first support part 251a of the support 250a, so that the clamping projections 221a of the contact holder 22a extend into the clamping slot 2516a, to securely connect or maintain the contact holder 22a in the side opening 2513a.

Similarly, there is a spacing space 254a between the first support part 251a of the support 250 and a second support part 252a of the support 250a. After assembling, the second portion 32a is located in the spacing space 254a, and abuts against the lower side surface of the first support part 251a facing the second support part 252a.

In this embodiment, the seal element 26a includes:
an end wall 2610a, and an annular peripheral side wall 2620a extending from the end wall 2610a. During assembling, the peripheral side wall 2620a surrounds and encloses the first support part 251a in a circumferential direction, to provide sealing between the support 250a and the shell 210. The end wall 2610a abuts against and covers a surface of the first support part 251a adjacent to the receiving cavity 27.

The end wall 2610a of the seal element 26a is further defined with:
an avoidance hole 261a, opposite to a port of a channel 2515a on the first support part 251a, to avoid or bare the port of the channel 2515a;
a contact hole 262a, configured to enable the electrical contact 23a to enter the receiving cavity 27 through the end wall 2610a; and
an avoidance hole 264a, opposite to a magnetic element 28a, to expose the magnetic element 28a accommodated and maintained at the first support part 251a.

The end wall 2610a of the seal element 26a is further defined with:
a groove 2611a, where the avoidance hole 261a is located in the groove 2611a.

On an airflow path sensed by the sensor 50a, as shown in FIG. 15 to FIG. 18, the sensor 50a is arranged on the lower side surface of the second portion 32a. The sensor 50a is generally a cube, and the sensor 50a has a first sensing surface 510a and a second sensing surface 520a that face away from each other. During implementation, the first sensing surface 510a abuts against or is bonded to the lower side surface of the second portion 32a. In the arrangement, the sensor 50a deviates from a central axis of the power supply mechanism 200. Specifically, the sensor 50a is close to the rear side 2160.

Correspondingly, the second portion 32a is provided with a first air hole 327a penetrating through the second portion 32a. Certainly, after assembling, the first sensing surface 510a is opposite to the first air hole 327a. A contact assembly combined with an upper surface of the second portion 32a is arranged to avoid the first air hole 327a. Namely, the electrical contact 23a and the contact holder 22a are arranged to avoid the first air hole 327a.

The channel 2515a is arranged on the first support part 251a of the support 250, and is communicated with the receiving cavity 27. The channel 2515a extends in the length direction of the power supply mechanism 200. In the length direction of the power supply mechanism 200, the channel 2515a is aligned with the first air hole 327a. The channel 2515a is spaced apart from the first air hole 327a, and there is a space between them. The channel 2515a is isolated from the side opening 2513a. Alternatively, the channel 2515a and the side opening 2513a are spaced apart.

After assembling, a seal element 29a is arranged between the channel 2515a of the first support part 251a and the first air hole 327a of the second portion 32a. The seal element 29a is configured to: provide a path of airflow communication between the channel 2515a and the first air hole 327a, and provide airtight sealing.

During mounting and fixing of the seal element 29a, the seal element 29a is approximately square, and abuts against and is combined between the upper side surface of the second portion 32a and the channel 2515a. During assembling, the contact holder 22a is provided with an accommodating cavity 222a facing the rear side 2160, and the seal element 29a at least partially extends into the accommodating cavity 222a for maintenance.

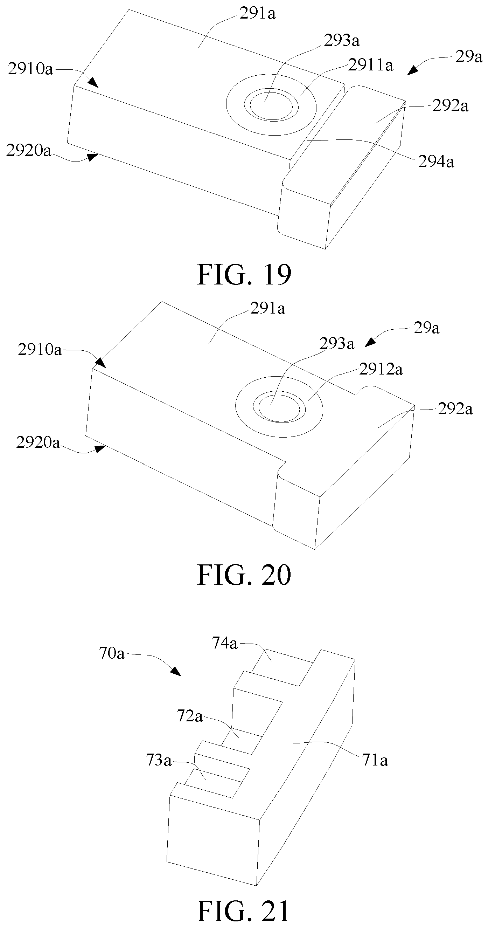

Specifically, for a structure of the seal element 29a, as shown in FIG. 19 and FIG. 20, the seal element 29a is roughly constructed into a block. The seal element 29a includes a portion 291a and a portion 292a that are arranged in sequence in the length direction. **In** the design, an extension length of the portion 291a is greater than an extension length of the portion 292a, and a thickness of the portion 291a is greater than a thickness of the portion 292a. A width of the portion 291a is less than a width of the portion 292a.

A second air hole 293a that penetrates through the portion 291a in the thickness direction is provided in the portion 291a. During assembling, the portion 291a partially extends into the accommodating cavity 222a, so as to fix the seal element 29a. The second air hole 293a is aligned with the channel 2515a and/or the first air hole 327a, thereby communicating the channel 2515a with the first air hole 327a. The portion 292a extends out of and abuts against an edge of the second portion 32a, to achieve a stop function, so as to prevent the portion 291a from moving.

The portion 291a includes a side first surface 2910a and a side second surface 2920a that face away from each other in the thickness direction. After assembling, the side first surface 2910a abuts against the first support part 251a, and the side second surface 2920a abuts against and is bonded to the upper side surface of the second portion 32a.

At least one closed annular first convex rib 2911a surrounding the second air hole 293a and/or the channel 2515a is arranged on the side first surface 2910a. At least one closed annular second convex rib 2912a surrounding the second air hole 293a and/or the first air hole 327a is arranged on the side first surface 2910a. Then, after assembling, the first convex rib 2911a and the second convex rib 2912a are pressed and compressed, to define interference fit between the portion 291a of the seal element 29a and the second portion 32a and/or the first support part 251a, which is advantageous for airtightness.

Then, after assembling, the first sensing surface 510a of the sensor 50a is in airflow communication with the receiving cavity 27 and/or the air inlet 213 through the first air hole 327a, the second air hole 293a, and the channel 2515a, to sense a pressure of an airflow inhaled by a user.

After assembling, the second sensing surface 520a of the sensor 50a is at least partially exposed in the spacing space 254a, and is communicated with an environmental atmosphere through the assembling gap, the gap, or the like in the power supply mechanism 200, to sense an environmental atmospheric pressure.

In a further implementation, the support 250a has a partition wall 2520a located between the spacing space 254a and the second support part 252a, to define and separate the spacing space 254a from the second support part 252a. The spacing space 254a of the support 250a further has an opening 259a facing or adjacent to the rear side 2160. A flexible seal element 70a at least partially extends into the spacing space 254a from the opening 259a, and is located between the lower side surface of the second portion 32a and the partition wall 2520a. During implementation, the seal element 70a at least partially supports the second portion 32a, to prevent the flexible second portion 32a from being pressed to deform.

The seal element 70a at least partially covers and surrounds or encloses the sensor 50a, to improve the sensing sensitivity and accuracy of the second sensing surface 520a.

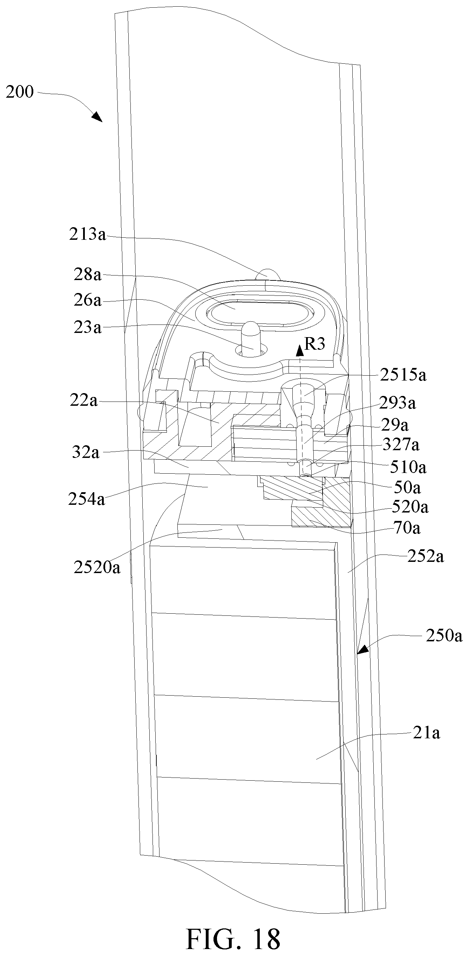

During implementation, the seal element 70a has a plurality of grooves adjacent to the lower side surface of the second portion 32a, such as a groove 72a, a groove 73a, and a groove 74a. After assembling, the sensor 50a at least partially extends into or is accommodated in the groove 72a, to avoid that the second sensing surface 520a of the sensor 50a is bonded or sealed by the seal element 70a. In FIG. 18, the second sensing surface 520a of the sensor 50a is spaced from an inner bottom wall of the groove 72a of the seal element 70a.

The groove 73a and the groove 74a are configured to accommodate and avoid one or more electronic devices such as a resistor and a capacitor that are arranged on the lower side surface of the second portion 32a. The seal element 70a further has an end wall 71a for blocking or covering the opening 259a, to block or cover the opening 259a after assembling.

Similarly, the power supply mechanism 200 in this embodiment further includes:
a charging interface 24a, and a charging circuit board 60a electrically connected to the charging interface 24a.

Correspondingly, the circuit board assembly 30a further includes:
a first portion 31a extending in the length direction, to arrange a light source 41a, an input response unit 42, an MCU controller 43a, an electronic device, and the like; and
a third portion 33a extending from the first portion 31a. The third portion 33a is connected to the charging circuit board 60a.

In this implementation, any two of the first portion 31a, the second portion 32a, and the third portion 33a of the circuit board assembly 30a are perpendicular to each other.

In some implementations, the first portion 31a and the second portion 32a may be flat and straight. The third portion 33a may be at least partially curved.

Similarly, the power supply mechanism 200 in this embodiment further includes:
a fastening component 230a adjacent to the second side 2140. The fastening component 230a clamps or fastens the first portion 31a to the retaining wall 255a of the support 250a from the second side 2140.

Alternatively, in some other implementations, the circuit board assembly 30 includes:
a first circuit board, defining the first portion 31a;
a second circuit board, defining the second portion 32a; and
a third circuit board defining the third portion 33a.

The first circuit board and/or the second circuit board and/or the third circuit board may be hard PCBs or soft PCBs. In some implementations, the first circuit board and/or the second circuit board and/or the third circuit board may be independently prepared or obtained and then connected through flat flexible cables. Alternatively, in some other implementations, the first circuit board and/or the second circuit board and/or the third circuit board are/is formed by bending different portions of another foldable or bendable circuit board.

It should be noted that, the specification and the accompanying drawings of the present application illustrate preferred embodiments of the present application, but the present application is not limited to the embodiments described in this specification. Further, a person of ordinary skill in the art may make improvements or modifications according to the foregoing description, and all the improvements and modifications shall fall within the protection scope of the appended claims of the present application.

## Claims

1. An electronic atomization device, comprising a first side and a second side which face away from each other in a width direction, and:
a heating element, configured to heat an aerosol-forming matrix to form an aerosol;
a battery cell, configured to supply power;
a charging assembly, configured to charge the battery cell; and
a circuit board assembly, at least comprising:
a first portion, located between the battery cell and the second side in the width direction of the electronic atomization device, wherein a controller is arranged on the first portion, and the controller is configured to control the battery cell to supply electric power to the heating element;
a second portion, extending from the first portion toward the first side, wherein the second portion is configured to be electrically connected to the heating element, to output the electric power of the battery cell to the heating element; and
a third portion, extending from the first portion toward the first side, wherein the third portion is connected to the charging assembly.

2. The electronic atomization device according to claim 1, comprising a near end and a far end which face away from each other in a length direction, wherein the third portion is closer to the far end than the second portion.

3. The electronic atomization device according to claim 1 or 2, wherein the second portion and/or the third portion are substantially perpendicular to the first portion.

4. The electronic atomization device according to claim 1 or 2, wherein the second portion and the third portion are perpendicular to each other;
alternatively, the second portion and the third portion are parallel to each other.

5. The electronic atomization device according to claim 1 or 2, wherein any two of the first portion, the second portion, and the third portion are perpendicular to each other.

6. The electronic atomization device according to claim 1 or 2, wherein the first portion is arranged perpendicular to the width direction of the electronic atomization device.

7. The electronic atomization device according to claim 1 or 2, wherein the second portion and the third portion are arranged on a same side of the first portion in a thickness direction of the electronic atomization device.

8. The electronic atomization device according to claim 1 or 2, wherein a length dimension of the first portion extending in the length direction of the electronic atomization device is greater than a width dimension of the second portion extending in the width direction of the electronic atomization device.

9. The electronic atomization device according to claim 8, wherein the length dimension of the first portion is between 40 mm and 60 mm;
and/or a width dimension of the second portion is between 10 mm and 18 mm;
and/or a width dimension of the third portion is between 6 mm and 12 mm.

10. The electronic atomization device according to claim 1 or 2, wherein the controller is arranged on a surface of the first portion that faces away from the battery cell.

11. The electronic atomization device according to claim 1 or 2, wherein the circuit board assembly further comprises:
a fourth portion, extending from the first portion toward the first side; a temperature sensor abutting against or adjacent to the battery cell is arranged on the fourth portion, to sense a temperature of the battery cell; and
the controller is configured to prevent or reduce the electric power output by the battery cell when a temperature sensed by the temperature sensor is greater than a preset threshold.

12. The electronic atomization device according to claim 11, wherein the temperature sensor is combined with or arranged on a surface of the fourth portion that faces away from the battery cell.

13. The electronic atomization device according to claim 11, wherein the fourth portion is located between the second portion and the third portion in the length direction of the electronic atomization device.

14. The electronic atomization device according to claim 11, wherein a width dimension of the fourth portion extending in the width direction of the electronic atomization device is less than a width dimension of the second portion or the third portion extending in the width direction of the electronic atomization device.

15. The electronic atomization device according to claim 1 or 2, wherein the circuit board assembly further comprises:
a fourth portion, extending from the first portion toward the first side; a thermistor abutting against or adjacent to the battery cell is arranged on the fourth portion; and
the controller is configured to prevent or reduce the battery cell from outputting electric power when an electrical characteristic of the thermistor exceeds a preset threshold.

16. The electronic atomization device according to claim 15, wherein the electrical characteristic comprises a voltage value and/or a resistance value.

17. The electronic atomization device according to claim 1 or 2, further comprising:
a plurality of light sources, configured to emit light,
wherein the controller is configured to control, based on a change in a positive electrode voltage or an output voltage of the battery cell, the plurality of light sources to emit light in different quantities.

18. The electronic atomization device according to claim 17, wherein the controller is configured to:
control, when the positive electrode voltage or the output voltage of the battery cell is greater than a first threshold, the plurality of light sources to emit light in a first quantity; and
control, when the positive electrode voltage or the output voltage of the battery cell is less than the first threshold, the plurality of light sources to emit light in a second quantity; and the second quantity is less than the first quantity.

19. The electronic atomization device according to claim 1 or 2, further comprising:
one or more light sources, configured to emit light, wherein the one or more light sources are arranged on a surface of the first portion that faces the second side.

20. The electronic atomization device according to claim 1 or 2, wherein the circuit board assembly comprises:
at least one substrate layer, and a conductive line and/or an electronic device arranged on the substrate layer; and the first portion, the second portion, or the third portion comprises a portion of the substrate layer.

21. The electronic atomization device according to claim 20, wherein the substrate layer comprises at least one of a polyimide layer, a polytetrafluoroethylene layer, a polycarbonate layer, a polyester layer, an aluminum foil layer, and a stainless steel layer.

22. The electronic atomization device according to claim 1 or 2, wherein hardness of the first portion is greater than hardness of the second portion and/or the third portion.

23. The electronic atomization device according to claim 1 or 2, wherein the first portion at least comprises:
a soft first substrate layer; and
a hard second substrate layer.

24. The electronic atomization device according to claim 1 or 2, wherein the first portion comprises a stainless steel layer.

25. The electronic atomization device according to claim 1 or 2, wherein the second portion and/or the third portion comprises an organic polymer layer.

26. The electronic atomization device according to claim 1 or 2, wherein the first portion, the second portion, and the third portion are formed by bending a sheet base material.

27. The electronic atomization device according to claim 1 or 2, wherein the second portion is in non-contact with the battery cell;
and/or the third portion at least partially abuts against or is at least partially combined with a surface of the battery cell.

28. The electronic atomization device according to claim 2, wherein the second portion is located between the battery cell and the near end.

29. The electronic atomization device according to claim 2, further comprising:
an electrical contact, electrically connected between the second portion and the heating element, wherein during use, the second portion is in conductive connection to the heating element through the electrical contact, to output the electric power of the battery cell to the heating element.

30. The electronic atomization device according to claim 29, wherein the second portion is provided with:
a contact connection portion, identified by a color or a pattern; and the electrical contact is electrically connected to the contact connection portion to form electrical conduction with the second portion.

31. The electronic atomization device according to claim 30, wherein the contact connection portion is identified and defined by a circle pattern that is formed on the second portion and has an identifiable color.

32. The electronic atomization device according to claim 30, further comprising:
a sensor, arranged or combined on the second portion, to sense an airflow flowing through the electronic atomization device during inhalation of a user;
the contact connection portion comprises a first contact connection portion and a second contact connection portion that are spaced apart; and the sensor is located between the first contact connection portion and the second contact connection portion.

33. The electronic atomization device according to claim 29, further comprising:
a support, a first support part and a second support part that are arranged in the length direction of the electronic atomization device, where the first support part is closer to the near end than the second support part;
the electrical contact is at least partially maintained at the first support part; and
the battery cell is at least partially maintained at the second support part.

34. The electronic atomization device according to claim 33, wherein the first support part is moulded by a mouldable material and at least partially surrounds the electrical contact.

35. The electronic atomization device according to claim 33, wherein the second portion is at least partially accommodated between the first support part and the second support part.

36. The electronic atomization device according to claim 1 or 2, further comprising:
a sensor, arranged or combined on the second portion, to sense a change in an airflow flowing through the electronic atomization device during inhalation of a user; and
the controller is configured to control, based on a sensing result of the sensor, the battery cell to supply the electric power to the heating element.

37. The electronic atomization device according to claim 1 or 2, further comprising:
a sensor, arranged or combined on the second portion, to sense a pressure difference between a pressure, caused by an airflow flowing through the electronic atomization device during inhalation of a user, and an environmental atmospheric pressure,
wherein the controller is configured to control, based on the pressure difference, the battery cell to supply the electric power to the heating element.

38. The electronic atomization device according to claim 37, wherein the controller is configured to control, when the pressure difference is greater than a preset threshold, the battery cell to supply the electric power to the heating element.

39. The electronic atomization device according to claim 37, wherein the controller is configured to control the battery cell to supply the electric power to the heating element proportionally or linearly according to the pressure difference.

40. The electronic atomization device according to claim 37, wherein a volume of the sensor is less than 12 mm3.

41. The electronic atomization device according to claim 37, wherein the sensor has a length of 2 to 3.5 mm, a width of 1.5 to 2.5 mm, and a thickness of 0.6 to 1.4 mm.

42. The electronic atomization device according to claim 37, wherein the sensor is a micro electro mechanical system (MEMS)-based sensor.

43. The electronic atomization device according to claim 37, wherein the sensor is arranged in a manner of deviating from a central axis of the electronic atomization device.

44. The electronic atomization device according to claim 37, wherein the sensor is basically square; and
the sensor is perpendicular to the length direction of the electronic atomization device, or the sensor is parallel to the length direction of the electronic atomization device.

45. The electronic atomization device according to claim 37, wherein the sensor comprises:
a first sensing surface, configured to sense the pressure caused by the airflow flowing through the electronic atomization device during the inhalation of the user; and a second sensing surface, configured to sense the environmental atmospheric pressure, wherein
the first sensing surface is combined with or abuts against the second portion; and
the second sensing surface is at least partially exposed inside the electronic atomization device.

46. The electronic atomization device according to claim 45, wherein the second portion comprises a soft substrate layer made of an organic polymer material; and
the first sensing surface is at least partially combined with the substrate layer, so that at least a portion of the substrate layer provides airtight sealing between the second portion and the first sensing surface.

47. The electronic atomization device according to claim 45, further comprising:
a support, configured to accommodate or maintain the battery cell; and
an air channel, at least partially defined on the support, to provide a channel for communicating the first sensing surface to the airflow flowing through the electronic atomization device during the inhalation.

48. The electronic atomization device according to claim 47, further comprising:
a flexible seal element, at least partially located between the second portion and the support and surrounding the air channel, to provide sealing between the second portion and the air channel.

49. The electronic atomization device according to claim 47, further comprising:
a first air hole, penetrating through two opposite sides of the second portion, to provide a channel for communicating the first sensing surface to the airflow of the air channel, wherein the first sensing surface covers the first air hole.

50. The electronic atomization device according to claim 47, wherein the air channel comprises: a first channel portion close to the first sensing surface and a second channel portion facing away from the first sensing surface; and
an angle is formed between the first channel portion and the second channel portion, or the first channel portion and the second channel portion are vertically arranged.

51. The electronic atomization device according to claim 47, wherein the air channel comprises: a first channel portion close to the first sensing surface and a second channel portion facing away from the first sensing surface; and a cross-sectional area of the first channel portion is smaller than a cross-sectional area of the second channel portion.

52. The electronic atomization device according to claim 48, wherein the seal element at least comprises:
a first surface, abutting against or combined with the second portion;
a second surface, abutting against or combined with the support; and
a second air hole, extending from the first surface to the second surface, to provide a channel for communicating the first sensing surface with the airflow of the air channel.

53. The electronic atomization device according to claim 52, wherein the seal element further comprises:
a first convex rib, located on the first surface, wherein the first convex rib defines at least one closed ring surrounding the second air hole;
and/or a second convex rib, located on the second surface, wherein the second convex rib defines at least one closed ring surrounding the second air hole and/or the air channel.

54. The electronic atomization device according to claim 52, wherein the second air hole deviates from a center of the seal element.

55. The electronic atomization device according to claim 48, wherein the seal element at least partially extends into the air channel.

56. The electronic atomization device according to claim 48, wherein the seal element comprises:
a base portion, at least partially located between the second portion and the support and surrounding the air channel, to provide sealing between the second portion and the air channel; and
an extension portion, extending away from the base portion and at least partially extending into the air channel.

57. The electronic atomization device according to claim 1 or 2, comprising:
a retaining wall, extending in the length direction of the electronic atomization device and arranged substantially perpendicular to the width direction of the electronic atomization device,
wherein the battery cell is at least partially accommodated between the retaining wall and the first side and abuts against the retaining wall; and
the first portion is at least partially accommodated between the retaining wall and the second side and abuts against the retaining wall.

58. The electronic atomization device according to claim 57, wherein a distance between the retaining wall and the first side is greater than a distance between the retaining wall and the second side.

59. The electronic atomization device according to claim 58, wherein a distance between the retaining wall and the first side is between 10 mm and 20 mm;
and/or a distance between the retaining wall and the second side is between 5 mm and 10 mm.

60. The electronic atomization device according to claim 57, further comprising:
a fastening component, at least partially accommodated between the first portion and the second side, to securely press the first portion against the retaining wall.

61. The electronic atomization device according to claim 57, wherein at least one convex post extending toward the second side is arranged on the retaining wall; and
a hole through which the convex post passes is provided in the first portion.

62. The electronic atomization device according to claim 1 or 2, wherein the first portion and the second portion are connected through a flat flexible cable;
and/or the first portion is connected to the third portion through a flat flexible cable.

63. The electronic atomization device according to claim 1 or 2, wherein the charging assembly comprises:
a charging circuit board and a charging interface combined with the charging circuit board;
a surface of the charging circuit board facing away from the charging interface is provided with:
a battery cell connection portion, wherein a positive electrode and negative electrode of the battery cell are connected to the battery cell connection portion; and
a circuit connection portion, wherein the third portion is connected to the circuit connection portion.

64. The electronic atomization device according to claim 63, wherein the battery cell connection portion and the circuit connection portion have different shapes and/or colors.

65. An electronic atomization device, comprising a first side and a second side which face away from each other in a width direction, and:
a heating element, configured to heat an aerosol-forming matrix to form an aerosol;
a battery cell, configured to supply power;
a charging assembly, configured to charge the battery cell; and
a circuit board assembly, at least comprising:
a first portion, located between the battery cell and the second side in the width direction of the electronic atomization device, wherein a controller is arranged on the first portion, and the controller is configured to control the battery cell to supply electric power to the heating element;
a second portion, extending from the first portion toward the first side, wherein a sensor is arranged on the second portion, to sense an airflow flowing through the electronic atomization device during inhalation of a user; and
a third portion, extending from the first portion toward the first side, wherein the third portion is connected to the charging assembly.

66. An electronic atomization device, comprising a first side and a second side which face away from each other in a width direction, and:
a heating element, configured to heat an aerosol-forming matrix to form an aerosol;
a battery cell, configured to supply power;
a charging assembly, configured to charge the battery cell; and
a circuit board assembly, at least comprising:
a first portion, located between the battery cell and the second side in the width direction of the electronic atomization device, wherein a controller is arranged on the first portion and at least configured to control the battery cell to supply electric power to the heating element;
a second portion, extending from the first portion toward the first side, to output the electric power of the battery cell to the heating element; and
a third portion, extending from the first portion toward the first side, wherein the third portion is connected to the charging assembly; and
any two of the first portion, the second portion, and the third portion are perpendicular to each other.

67. An electronic atomization device, comprising a first side and a second side which face away from each other in a width direction, and:
a heating element, configured to heat an aerosol-forming matrix to form an aerosol;
a battery cell, configured to supply power; and
a circuit board assembly, at least comprising:
a first portion, located between the battery cell and the second side in the width direction of the electronic atomization device, wherein a controller is arranged on the first portion and at least configured to control the battery cell to supply electric power to the heating element;
a second portion, extending from the first portion toward the first side, to output the electric power of the battery cell to the heating element,
wherein the first portion comprises a stainless steel layer and a flexible organic polymer layer combined with the stainless steel layer.

68. An electronic atomization device, comprising a first side and a second side which face away from each other in a width direction, and:
a heating element, configured to heat an aerosol-forming matrix to form an aerosol;
a battery cell, configured to supply power;
a first circuit board, located between the battery cell and the second side in the width direction of the electronic atomization device, wherein a first circuit board is configured to control the battery cell to supply electric power to the heating element; and
a second circuit board, located between the heating element and the battery cell in a length direction of the electronic atomization device, wherein a sensor is arranged on the second circuit board, to sense an airflow flowing through the electronic atomization device during inhalation of a user; and
the first circuit board and the second circuit board are connected through a flat flexible cable.

69. An electronic atomization device, comprising a first side and a second side which face away from each other in a width direction, and:
a heating element, configured to heat an aerosol-forming matrix to form an aerosol;
a battery cell, configured to supply power; and
a circuit board assembly, at least comprising:
a first portion, located between the battery cell and the second side in the width direction of the electronic atomization device, wherein a controller is arranged on the first portion and at least configured to control the battery cell to supply electric power to the heating element;
a second portion, extending from the first portion toward the first side, wherein a sensor is arranged on the second portion, to sense an airflow flowing through the electronic atomization device during inhalation of a user; and
a retaining wall, extending in the length direction of the electronic atomization device and arranged substantially perpendicular to the width direction of the electronic atomization device,
wherein the battery cell is at least partially accommodated or maintained between the retaining wall and the first side and abuts against the retaining wall; and
the first portion is at least partially accommodated or maintained between the retaining wall and the second side and abuts against the retaining wall.

70. A power supply mechanism for an electronic atomization device, configured to supply power to an atomizer of the electronic atomization device, and comprising a first side and a second side which face away from each other in a width direction, and:
a receiving cavity, configured to receive at least a portion of the atomizer;
a battery cell, configured to supply power;
a charging assembly, configured to charge the battery cell; and
a circuit board assembly, at least comprising:
a first portion, located between the battery cell and the second side in the width direction of the power supply mechanism, wherein a controller being arranged on the first portion and at least configured to control the battery cell to supply electric power to the atomizer;
a second portion, extending from the first portion toward the first side, wherein the second portion being configured to output the electric power of the battery cell to the atomizer; and
a third portion, extending from the first portion toward the first side in the width direction of the power supply mechanism, wherein the third portion is connected to the charging assembly.

71. A circuit board for an electronic atomization device, having a first end and a second end that deviate from each other in a length direction, and a first side and a second side that extend between the first end and the second end and deviate from each other, wherein the circuit board comprises:
a first portion, extending between the first end and the second end, wherein a controller is arranged on the first portion;
a second portion, extending from the first portion toward the first side and being close to the first end, wherein a sensor for sensing an airflow is arranged on the second portion; and
a third portion, extending from the first portion toward the first side and being close to the second end, wherein the third portion is configured to be connected to a charging assembly that charges the electronic atomization device.
